# EUROPEAN PATENT APPLICATION

(11) **EP 4 679 853 A1**
(43) Date of publication of application: **14.01.2026**
(21) Application number: 25189045.5
(22) Date of filing: 11.07.2025
(51) Int. Cl.: H04N 25/581, H04N 25/78, H04N 25/778, H04N 25/51, H04N 25/59, H04N 25/587

(54) **IMAGING DEVICE FOR HIGH DYNAMIC RANGE**

(30) Priority: 11.07.2024 KR 20240091897
(71) Applicant: SK hynix Inc., Bubal-eub Icheon-si Gyeonggi-do 17336 (KR)
(72) Inventor: PARK, Yu Jin, 17336 Icheon-si, Gyeonggi-do (KR)
(74) Representative: Isarpatent

(57) **Abstract**

An imaging device that generates a high dynamic range (HDR) image is disclosed. The imaging device includes: a split transistor configured to distinguish between a first time during which first pixel data of a first pixel is generated and a second time during which second pixel data of at least one second pixel is generated; a first photoelectric conversion element, included in the first pixel, connected to a first electrode of the split transistor through a first transfer transistor; a second photoelectric conversion element, included in the second pixel, connected to a second electrode of the split transistor through a second transfer transistor; a floating diffusion region that accumulates photocharges generated by the first photoelectric conversion element or the second photoelectric conversion element; a capacitor that adjusts capacitance of the floating diffusion region; and a dual conversion gain (DCG) transistor connected between the capacitor and the floating diffusion region.

## Description

### TECHNICAL FIELD

The technology and implementations disclosed in this patent document generally relate to an imaging device capable of generating a high dynamic range (HDR) image.

### BACKGROUND

An image sensing device is a device for capturing optical images by converting light into electrical signals using a photosensitive semiconductor material which reacts to light. With the development of automotive, medical, computer and communication industries, the demand for high-performance image sensing devices is increasing in various fields such as smartphones, digital cameras, game machines, Internet of Things (IoT), robots, security cameras and medical micro cameras, etc.

The image sensing devices may be roughly divided into Charge Coupled Device (CCD) image sensing devices and Complementary Metal Oxide Semiconductor (CMOS) image sensing devices. CCD image sensing devices offer a better image quality, but tend to consume more power and are larger as compared to the CMOS image sensing devices. CMOS image sensing devices are smaller in size and consume less power than CCD image sensing devices. Furthermore, CMOS sensors are fabricated using the CMOS fabrication technology, and thus photosensitive elements and other signal processing circuitry can be integrated into a single chip, enabling the production of miniaturized image sensing devices at a lower cost. For these reasons, CMOS image sensing devices are being developed for many applications including mobile devices.

### SUMMARY

Various embodiments of the present disclosure relate to an image sensing device that generates a high dynamic range (HDR) image using an optimal method from among various (for example, multiple) methods.

In accordance with an embodiment of the present disclosure, an imaging device may include: a split transistor configured to distinguish between a first time during which first pixel data of a first pixel is generated and a second time during which second pixel data of at least one second pixel is generated; a first photoelectric conversion element connected to a first electrode of the split transistor through a first transfer transistor and included in the first pixel; a second photoelectric conversion element connected to a second electrode of the split transistor through a second transfer transistor and included in the second pixel; a floating diffusion region configured to accumulate photocharges generated by the first photoelectric conversion element or the second photoelectric conversion element; a capacitor configured to adjust capacitance of the floating diffusion region; and a dual conversion gain (DCG) transistor connected between the capacitor and the floating diffusion region and configured to control the capacitance of the floating diffusion region.

In accordance with another embodiment of the present disclosure, an imaging device may include a multi-pixel, a signal controller, and an image synthesizer. The multi-pixel may include a split transistor configured to distinguish between a first time during which first pixel data of a first pixel is generated and a second time during which second pixel data of at least one second pixel is generated,, a first photoelectric conversion element connected to a first electrode of the split transistor through a first transfer transistor and included in the first pixel, a second photoelectric conversion element connected to a second electrode of the split transistor through a second transfer transistor and included in the second pixel, a floating diffusion region configured to accumulate photocharges generated by the first photoelectric conversion element or the second photoelectric conversion element, a capacitor configured to adjust capacitance of the floating diffusion region, and a dual conversion gain (DCG) transistor connected between the capacitor and the floating diffusion region and configured to control the capacitance of the floating diffusion region. The signal controller may generate a control signal to control each of the split transistor and the DCG transistor. The image synthesizer may generate a high dynamic range (HDR) image by synthesizing first image data generated based on the first pixel and second image data generated based on the at least one second pixel.

In accordance with another embodiment of the present disclosure, an image sensing method may include: generating first pixel data based on first photocharges generated by a first photoelectric conversion element, when a split transistor is turned off and a dual conversion gain (DCG) transistor is turned on, wherein the split transistor is configured to distinguish between photocharges generated by the first photoelectric conversion element and at least one second photoelectric conversion element; adjusting, to a first capacitance, capacitance of a floating diffusion region configured to accumulate second photocharges generated by the at least one second photoelectric conversion element, when the split transistor is turned on and the DCG transistor is turned on; generating second pixel data corresponding to a first conversion gain based on the second photocharges; adjusting the capacitance to a second capacitance when the split transistor is turned on and the DCG transistor is turned off; and generating third pixel data corresponding to a second conversion gain based on the second photocharges.

It is to be understood that both the foregoing general description and the following detailed description of the present disclosure are illustrative and explanatory and are intended to provide further explanation of the present disclosure as claimed.

### BRIEF DESCRIPTION OF THE DRAWINGS

The above and other features and beneficial aspects of the present disclosure will become readily apparent with reference to the following detailed description when considered in conjunction with the accompanying drawings.
FIG. 1 is a block diagram illustrating an example of an imaging device according to an embodiment of the present disclosure.
FIG. 2 is a graph illustrating an example of responses depending on illuminance of incident light applied to a high-transmittance pixel and a low-transmittance pixel according to an embodiment of the present disclosure.
FIGS. 3A and 3B are circuit diagrams illustrating examples of a pixel group according to an embodiment of the present disclosure.
FIG. 4 is a diagram illustrating a pixel group, a plurality of microlenses, a plurality of ADCs, and a plurality of pixels corresponding thereto according to an embodiment of the present disclosure.
FIG. 5 is a cross-sectional view illustrating an example of a high-transmittance pixel and a low-transmittance pixel according to an embodiment of the present disclosure.
FIG. 6 is a timing diagram illustrating example operations of constituent elements included in the circuit diagram of FIG. 3A according to an embodiment of the present disclosure.
FIG. 7 is a diagram illustrating example operations of an image synthesizer according to an embodiment of the present disclosure.
FIG. 8 is a block diagram illustrating an example of a computing device corresponding to an image signal processor (ISP) of FIG. 1 according to an embodiment of the present disclosure.

### DETAILED DESCRIPTION

The present disclosure provides implementations and examples of an imaging device capable of generating a high dynamic range (HDR) image that may be used in configurations to substantially address one or more technical or engineering issues and to mitigate limitations or disadvantages encountered in some other image sensing devices. Some implementations of the present disclosure relate to an imaging device that generates a high dynamic range (HDR) image using an optimal method from among various methods. In recognition of the issues above, the present disclosure may provide an imaging device that controls overflow charges of a low-transmittance photoelectric conversion element using a single shared capacitor, and controls electrostatic capacitance of a floating diffusion (FD) region of a high-transmittance photoelectric conversion element using the single shared capacitor, so that the imaging device can efficiently generate an HDR image having a maximum dynamic range.

Reference will now be made in detail to the embodiments of the present disclosure, examples of which are illustrated in the accompanying drawings. Wherever possible, the same reference numbers will be used throughout the drawings to refer to the same or like parts. While the present disclosure is susceptible to various modifications and alternative forms, specific embodiments thereof are shown by way of example in the drawings. However, the present disclosure should not be construed as being limited to the embodiments set forth herein.

Hereinafter, various embodiments will be described with reference to the accompanying drawings. However, it should be understood that the present disclosure is not limited to specific embodiments, but includes various modifications, equivalents and/or alternatives of the embodiments. The embodiments of the present disclosure may provide a variety of effects capable of being directly or indirectly recognized through the present disclosure.

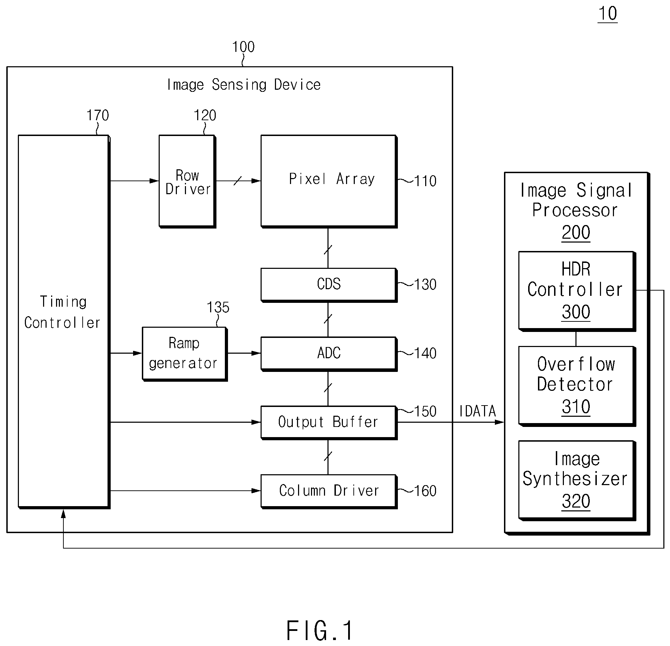

FIG. 1 is a block diagram illustrating an example of an imaging device 10 according to an embodiment of the present disclosure.

Referring to FIG. 1, the imaging device 10 may refer to a device, for example, a digital still camera for photographing still images or a digital video camera for photographing moving images. For example, the imaging device 10 may be implemented as a Digital Single Lens Reflex (DSLR) camera, a mirrorless camera, or a smartphone, and other devices for capturing images. The imaging device 10 may include a device having both a lens and an image pickup element such that the device can capture (or photograph) a target object and can thus create an image of the target object.

In some implementations, the imaging device 10 may include an image sensing device 100 and an image signal processor (ISP) 200.

The image sensing device 100 may be a Complementary Metal Oxide Semiconductor Image Sensor (CIS) for converting incident light into electrical signals. The image sensing device 100 may adjust the ON/OFF operations, an exposure time, a conversion gain, an analog gain, etc. by the image signal processor (ISP) 200. The image sensing device 100 may convert incident light into electrical signals on a pixel basis, thereby generating image data (IDATA). The image sensing device 100 may include a plurality of pixels having different sensitivities. In this case, the sensitivity may refer to an increase (or an increase in response) of image data (IDATA) with respect to an increase in the intensity of incident light. That is, as the sensitivity increases, the amount of increase in image data (IDATA) with respect to an increase in the intensity of incident light also increases. As the sensitivity decreases, the amount of increase in image data (IDATA) with respect to the amount of increase in the intensity of incident light also decreases. The sensitivity may be determined based on light transmittance, a conversion gain, an exposure time, an analog gain, etc.

The image sensing device 100 may include a pixel array 110, a row driver 120, a correlated double sampling (CDS) circuit 130, a ramp generator 135, an analog-to-digital converter (ADC) 140, an output buffer 150, a column driver 160 and a timing controller 170. The components of the image sensing device 100 illustrated in FIG. 1 are discussed by way of example only, and the present disclosure encompasses numerous other changes, substitutions, variations, alterations, and modifications.

In some implementations, the pixel array 110 may include a plurality of pixels arranged in rows and columns. In one example, the plurality of pixels can be arranged in a two-dimensional (2D) pixel array including rows and columns. In another example, the plurality of pixels can be arranged in a three-dimensional (3D) pixel array. The plurality of pixels may convert an optical signal into an electrical signal on a pixel basis or a pixel group basis, where the pixels in a pixel group share at least certain internal circuitry. The pixel array 110 may receive driving signals, including a row selection signal, a pixel reset signal and a transfer signal, from the row driver 120. Upon receiving the driving signal, corresponding imaging pixels in the pixel array 110 may be activated to perform the operations corresponding to the row selection signal, the pixel reset signal, and the transfer signal.

In some implementations, the row driver 120 may activate the pixel array 110 to perform certain operations on the pixels included in the corresponding row based on commands and control signals provided by the timing controller 170. In some implementations, the row driver 120 may select one or more imaging pixels arranged in one or more rows of the pixel array 110. The row driver 120 may generate a row selection signal to select one or more rows among the plurality of rows. The row driver 120 may sequentially enable the pixel reset signal for resetting the pixels corresponding to at least one selected row, and the transfer signal for the pixels corresponding to the at least one selected row. Alternatively, the row driver 120 may sequentially enable the pixel transfer signal for the pixels corresponding to at least one selected row, and the reset signal for the pixels corresponding to the at least one selected row. Thus, a reference signal and an image signal, which are analog signals generated by each of the pixels of the selected row, may be sequentially transferred to the CDS circuit 130. The reference signal may be an electrical signal that is provided to the CDS circuit 130 when a sensing node of a pixel (e.g., a floating diffusion region) is reset, and the image signal may be an electrical signal that is provided to the CDS circuit 130 when photocharges generated by the pixel are accumulated in the sensing node. The reference signal indicating unique reset noise of each pixel and the image signal indicating the intensity of incident light may be generically referred to as a pixel signal in the appropriate context.

In some implementations, CMOS image sensors may use correlated double sampling (CDS) to remove undesired offset values of pixels known as the fixed pattern noise by sampling a pixel signal twice to remove the difference between these two samples. In one example, the correlated double sampling (CDS) may remove the undesired offset value of pixels by comparing pixel output voltages obtained before and after photocharges generated by incident light are accumulated in the sensing node so that only pixel output voltages based on the incident light can be measured. In some embodiments of the present disclosure, the CDS circuit 130 may sequentially sample and hold voltage levels of the reference signal and the image signal, which are provided to each of a plurality of column lines from the pixel array 110. That is, the CDS circuit 130 may sample and hold the levels of the reference signal and image signal corresponding to each column of the pixel array 110.

In some implementations, the CDS circuit 130 may transfer, to the ADC 140, the reference signal and the image signal of each of the columns as a correlate double sampling (CDS) signal based on control signals from the timing controller 170.

The ramp generator 135 may generate a ramp signal required for the analog-to-digital conversion (ADC) operation of the ADC 140 upon receiving a control signal from the timing controller 170, and may supply the ramp signal to the ADC 140. The ramp generator 135 (also referred to as a ramp signal generating circuit) may generate a ramp signal (or a ramp voltage) in which the level increases (up) or decreases (down) at a constant slope. The slope of the ramp signal may vary according to an analog gain setting. The ramp signal may be provided as a reference voltage to the ADC 140.

In some implementations, the ADC 140 may receive CDS signals for each column from the CDS circuit 130, may convert the CDS signals into digital signals, and may output the digital signals. In some embodiments, the ADC 140 may convert the correlate double sampling (CD) signal generated by the CDS circuit 130 for each of the columns into a digital signal, and may output the digital signal.

In some implementations, The ADC 140 may convert CDS signals for each column from the CDS circuit 130 into the digital signals based on the ramp signal provided from the ramp generator 135. the ADC 140 may include a plurality of column counters. Each column of the pixel array 110 is coupled to a column counter, and image data may be generated by converting the correlate double sampling (CDS) signals received from each column into digital signals using the column counter. In another embodiment, the ADC 140 may include a global counter to convert the correlate double sampling (CDS) signals corresponding to the columns into digital signals using a global code provided from the global counter.

In some implementations, the output buffer 150 may temporarily hold the column-based image data provided from the ADC 140 to output the image data. In one example, the image data provided to the output buffer 150 from the ADC 140 may be temporarily stored in the output buffer 150 based on control signals of the timing controller 170. The output buffer 150 may provide an interface to compensate for data rate differences or transfer rate differences between the image sensing device 100 and other devices.

In some implementations, the column driver 160 may select a column of the output buffer 150 upon receiving a control signal from the timing controller 170, and sequentially output the image data (IDATA), which may be temporarily stored in the selected column of the output buffer 150. In some implementations, upon receiving an address signal from the timing controller 170, the column driver 160 may generate a column selection signal based on the address signal and select a column of the output buffer 150. An output signal from the selected column of the output buffer 150 is output as the image data (IDATA).

In some implementations, the timing controller 170 may control operations of the row driver 120, the ADC 140, the output buffer 150, and the column driver 160.

The timing controller 170 may provide at least one of the row driver 120, the CDS circuit 130, the ADC 140, the output buffer 150, and the column driver 160 with a clock signal required for the operations of the respective components of the image sensing device 100, a control signal for timing control, and address signals for selecting a row or column. In some embodiments, the timing controller 170 may include a logic control circuit, a phase-locked loop (PLL) circuit, a timing control circuit, a communication interface circuit, and other circuits.

In some implementations, the timing controller 170 may control the sensitivity of each of the pixels included in the pixel array 110. The sensitivity of each pixel may be determined by a light transmittance and a conversion gain. The light transmittance may refer to a ratio of the intensity of light reaching an element (a photoelectric conversion element to be described later) that converts light into charges within the pixel to the intensity of incident light applied to the pixel. The sensitivity of each pixel may be determined by light transmittance and a conversion gain. The conversion gain may refer to the ratio of a level (i.e., voltage) of the pixel signal obtained by charge conversion to the amount of charges generated in the pixel. The higher the light transmittance or the higher the conversion gain, the higher the sensitivity of the pixel. Conversely, the lower the light transmittance or the lower the conversion gain, the lower the sensitivity of the pixel.

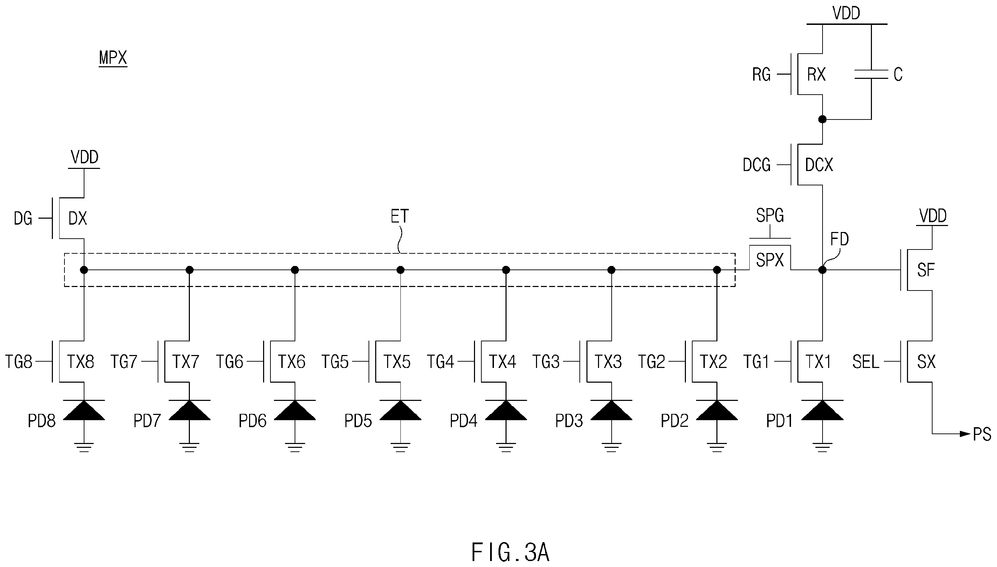

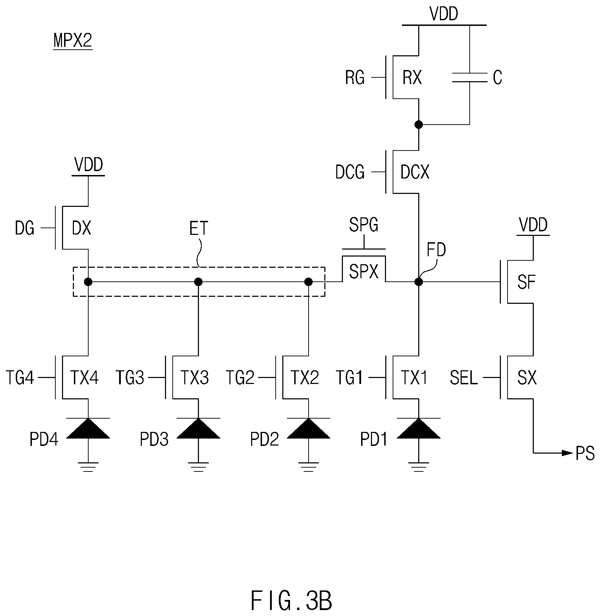

In some implementations, the light transmittance may be fixed in advance for each pixel, and the conversion gain may be a controllable item. The timing controller 170 may control the row driver 120 that supplies a control signal to the pixel array 110 to distinguish between pixel signals of a high-transmittance pixel and a low-transmittance pixel. In addition, the timing controller 170 may control the row driver 120 that supplies a control signal to the pixel array 110 to control the conversion gain of each pixel. In one example, a method for selecting a high-transmittance pixel and a low-transmittance pixel by the timing controller 170 and a method for controlling a conversion gain to control the sensitivity of the high-transmittance pixel and the sensitivity of the low-transmittance pixel by the timing controller 170 is described herein below with reference to FIGS. 3A and 3B.

In some implementations, the image signal processor (ISP) 200 may perform image processing of image data received from the image sensing device 100. The image signal processor (ISP) 200 may reduce noise of image data, and may perform various kinds of image signal processing (e.g. interpolation, synthesis, gamma correction, color filter array interpolation, color matrix, color correction, color enhancement, lens distortion correction, etc.) for image-quality improvement of the image data (IDATA). In addition, the image signal processor (ISP) 200 may compress image data that has been created by execution of image signal processing for image-quality improvement, such that the image signal processor (ISP) 200 can create an image file using the compressed image data. Alternatively, the image signal processor (ISP) 200 may recover image data from the image file. In this instance, the scheme for compressing such image data may be a reversible format or an irreversible format. As a representative example of such compression format, in tan implementation using a still image, Joint Photographic Experts Group (JPEG) format, JPEG 2000 format, or the like may be used. In addition, in an implementation using moving images, a plurality of frames can be compressed according to Moving Picture Experts Group (MPEG) standards such that moving image files can be created. For example, the image files may be created according to Exchangeable image file format (Exif) standards.

In some implementations, the image data (IDATA) generated from the image signal processor (ISP) 200 may be stored in an internal memory of the imaging device 10 or an external memory either in response to a user request or in an automatic manner, such that the stored image data (IDATA) may be displayed through a display. In addition, the image signal processor (ISP) 200 may perform unclearness processing, blur processing, edge emphasis processing, image analysis processing, image recognition processing, image effect processing, or the like.

In addition, the image signal processor (ISP) 200 may perform display image signal processing for the display. For example, the image signal processor (ISP) 200 may perform brightness level adjustment, color correction, contrast adjustment, outline emphasis adjustment, screen division processing, character image generation, and image synthesis processing, or the like.

In some implementations, the image signal processor (ISP) 200 may include a high dynamic range (HDR) controller 300, an overflow detector 310, and an image synthesizer 320. In one example, the HDR controller 300, the overflow detector 310, and the image synthesizer 320 may be implemented independently of the image signal processor (ISP) 200. The components of the image signal processor (ISP) 200 illustrated in FIG. 1 are discussed by way of example only, and the present disclosure encompasses numerous other changes, substitutions, variations, alterations, and modifications. For example, the HDR controller 300 may be included in the image sensing device 100. In an example, the HDR controller 300 may correspond to a signal controller that controls signals generated by the timing controller 170 through a control signal. For example, the overflow sensor 310 may be included in or omitted from the image sensing device 100.

In some implementations, the HDR controller 300 may control at least one of the components of the image sensing device 100 so that each of the pixels of the image sensing device 100 may have an optimal dynamic range. In one example, the HDR controller 300 may transmit a control signal for controlling each component of the image sensing device 100 to the timing controller 170. For example, the HDR controller 300 may control the timing controller 170 of the image sensing device 100.

In some implementations, the overflow detector 310 may detect that photocharges greater than a threshold value are generated from pixels included in the pixel array 110. In one example, the overflow detector 310 may transmit a detection signal to the HDR controller 300 based on detecting that photocharges greater than a threshold value are generated from pixels included in the pixel array 110.

In addition, the image synthesizer 320 may generate an HDR image by synthesizing at least two images having different sensitivities. For example, the image sensing device 100 may output a low-sensitivity image generated from a low-sensitivity pixel with a relatively lower sensitivity and a high-sensitivity image generated from a high-sensitivity pixel with a relatively higher sensitivity. The image signal processor (ISP) 200 may combine the low-sensitivity image and the high-sensitivity image, resulting in formation of an HDR image. Here, low-sensitivity and high-sensitivity are relative concepts, the image sensing device 100 may generate image data (IDATA) having at least N different sensitivities (where N is an integer of 2 or more), and the image synthesizer 320 may generate the HDR image using the resultant image data (IDATA).

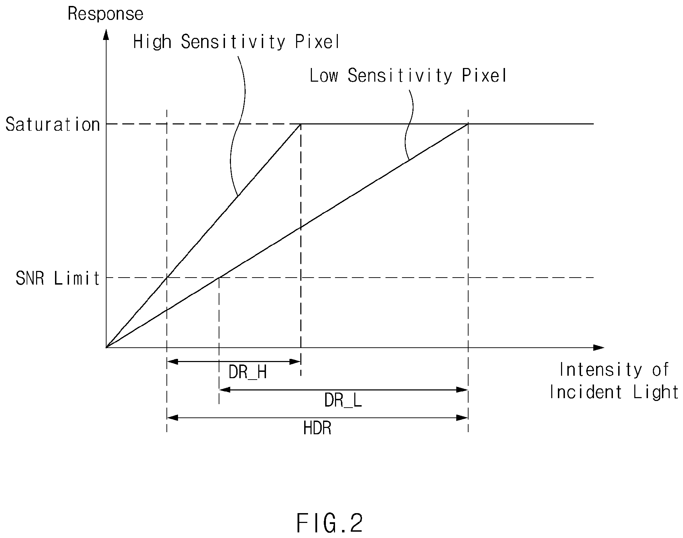

FIG. 2 is a graph illustrating an example of responses depending on illuminance of incident light applied to a high-sensitivity pixel and a low-sensitivity pixel according to an embodiment of the present disclosure.

Referring to FIG. 2, in association with a high-sensitivity pixel having a relatively larger amount of increase in response according to an increase in the intensity of incident light and a low-sensitivity pixel having a relatively smaller amount of increase in response according to an increase in the intensity of incident light, a response of the high-sensitivity pixel and a response of the low-sensitivity pixel are changed depending on the intensity of incident light applied to the corresponding pixel. Here, the response may refer to image data (IDATA) of the corresponding pixel. In one example, the response may have a signal-to-noise ratio (SNR) limit (denoted by SNR limit) and a saturation level (denoted by Saturation).

In accordance with implementations of the present disclosure, two different responses are shown, one of which is a signal-to-noise ratio (SNR) threshold level (denoted by "SNR Limit") and the other of which is a saturation level (denoted by "Saturation). The signal-to-noise ratio (SNR) threshold level refers to a threshold value that can satisfy a predetermined reference SNR. A response less than the SNR threshold level may be treated as an invalid response not satisfying the reference SNR, and a response greater than the SNR threshold level may be treated as a valid response satisfying the reference SNR. The reference SNR may be determined experimentally in consideration of characteristics of the image sensing device 100 and system requirements.

In some implementations, a saturation level refers to a maximum level that indicates the intensity of incident light. The saturation level may be determined by the capability (e.g., capacitance of a photoelectric conversion element) by which the pixel can convert the intensity of incident light into photocharges, the capability (e.g., capacitance of a floating diffusion (FD) region) by which photocharges can be converted into analog signals, and the capability (e.g., an input range of the ADC) by which analog signals can be converted into digital signals. As the intensity of incident light increases, the response may increase in proportion to the intensity of incident light until the response reaches the saturation level. After the response reaches the saturation level, the response may not increase although the intensity of incident light increases. For example, after the response reaches the saturation level, the response may have the same value as the saturation value and not increase above the saturation level.

In some implementations, the valid response of each pixel may refer to a response that can indicate the intensity of incident light while satisfying the reference SNR. The range of the intensity of incident light corresponding to the valid response of a pixel may be referred to as a dynamic range of the pixel. That is, the dynamic range of the pixel may refer to the incident-light intensity range in which each pixel has a valid response.

In some implementations, the high-sensitivity pixel provides the response having a relatively large increase in response to an increase in the intensity of incident light. Thus, the response of the high-sensitivity pixel may have a relatively greater slope in response to the increase in intensity of incident light until the response reaches the saturation level and have a fixed level corresponding to the saturation level regardless of the increase in the intensity of incident light after the response reaches the saturation level.

In some implementations, the low-sensitivity pixel provides the response having a relatively small increase in response to an increase in the intensity of incident light. Thus, the response of the low-sensitivity pixel may increase with a relatively smaller slope in response to the increase in intensity of incident light until the response reaches the saturation level, and have a fixed level corresponding to the saturation level regardless of the increase in the intensity of incident light after the response reaches the saturation level.

As illustrated in FIG. 2, a minimum value of a high-sensitivity pixel dynamic range (DR_H) may be less than a minimum value of a low-sensitivity pixel dynamic range (DR_L), and a maximum value of the high-sensitivity pixel dynamic range (DR_H) may be less than a maximum value of the low-sensitivity pixel dynamic range (DR_L). Therefore, in a low-illuminance range in which the intensity of incident light is relatively small, the high-sensitivity pixel may be more suitably used to sense the intensity of incident light. In a high-illuminance range in which the intensity of incident light is relatively large, the low-sensitivity pixel may be more suitably used to sense the intensity of incident light.

In some implementations, high dynamic range (HDR) can be implemented using both a response of the high-sensitivity pixel suitable for the low-illuminance range and a response of the low-sensitivity pixel suitable for the high-illuminance range. In other words, as compared to the other case in which only one of the high-transmittance pixel and the low-sensitivity pixel is used, the above-mentioned case in which both the high-sensitivity pixel and the low-sensitivity pixel are used can allow the overall pixel array to have a high dynamic range (HDR) corresponding to a specific range from the minimum value of the high-sensitivity pixel dynamic range to the maximum value of the low-sensitivity pixel dynamic range. To this end, at least a portion of the high-sensitivity pixel dynamic range and at least a portion of the low-sensitivity pixel dynamic range may overlap each other.

In some implementations, a method for synthesizing a high dynamic range (HDR) image corresponding to the high dynamic range (HDR) using the high-sensitivity pixel and the low-sensitivity pixel may be implemented as a method for synthesizing the HDR image by interpolating and calculating (e.g., summing) the high-sensitivity-pixel response and the low-sensitivity-pixel response, and/or a method for forming an image based on the high-sensitivity-pixel response at a low-illuminance level and forming an image based on the low-sensitivity-pixel response at a high-illuminance level, without being limited thereto.

As shown in FIG. 2, when the sensitivity of each pixel (i.e., a slope of response) is adjusted, the dynamic range of the corresponding pixel can be adjusted. The sensitivity of the pixel may be determined based on at least one of light transmittance and conversion gain that are sensitivity items capable of determining the pixel sensitivity. Accordingly, the HDR controller 300 may adjust the dynamic range of each pixel by adjusting controllable items from among the above-described sensitivity items (e.g., light transmittance and conversion gain).

In some implementations, the HDR controller 300 may control at least one of the constituent elements of the image sensing device 100 based on characteristics of the scene and characteristics of the controllable items, so that the pixels of the image sensing device 100 may have the optimal dynamic range.

FIGS. 3A and 3B are circuit diagrams illustrating examples of the pixel group according to an embodiment of the present disclosure.

Referring to FIG. 3A, a multi-pixel (MPX) may be one of a pixel group including one or more pixels included in the pixel array 110. Although FIG. 3A illustrates one multi-pixel (MPX) for convenience of description, other pixel groups may also have substantially the same structure as the multi-pixel (MPX) or may perform the same operation as the multi-pixel (MPX).

In some implementations, the multi-pixel (MPX) may include photoelectric conversion elements (PD1~PD8), transfer transistors (TX1~TX8), a drain transistor (DX), a split transistor (SPX), a reset transistor (RX), a floating diffusion region (FD), a dual conversion gain (DCG) transistor (DCX), a capacitor (C), a source follower transistor (SF), and a selection transistor (SX). In one example, the source follower transistor (SF) and the selection transistor (SX) may correspond to a read controller that performs activation of the multi-pixel (MPX) (e.g., an operation for selecting a row including the multi-pixel MPX) and performs readout of the multi-pixel (MPX). Although FIG. 3A illustrates that the multi-pixel (MPX) includes eight photoelectric conversion elements (PD1~PD8) for convenience of description, other implementations are also possible, and it should be noted that the multi-pixel (MPX) of FIG. 3A may also have a structure having one or more photoelectric conversion elements according to another embodiment. In that instance, one or more transfer transistors may be provided corresponding to one or more photoelectric conversion elements.

In some implementations, the multi-pixel (MPX) may correspond to a structure including one or more pixels. In one example, the multi-pixel (MPX) may include a first pixel and one or more second pixels. For example, the first pixel of the multi-pixel (MPX) may include a first photoelectric conversion element (PD1), a floating diffusion region (FD), a split transistor (SPX), a capacitor (C), a DCG transistor (DCX), and a reset transistor (RX). In addition, the second pixel of the multi-pixel (MPX) may include a second photoelectric conversion element (PD2), a floating diffusion region (FD), a split transistor (SPX), a capacitor (C), a DCG transistor (DCX), and a reset transistor (RX). That is, the multi-pixel (MPX) may be configured such that the first pixel and the second pixel share the split transistor (SPX), the floating diffusion region (FD), the capacitor (C), and the DCG transistor (DCX). In one example, the multi-pixel (MPX) may include one or more second pixels. For example, at least one second pixel may include a pixel including a second photoelectric conversion element (PD2), a pixel including a third photoelectric conversion element (PD3), a pixel including a fourth photoelectric conversion element (PD4), a pixel including a fifth photoelectric conversion element (PD5), a pixel including a sixth photoelectric conversion element (PD6), a pixel including a seventh photoelectric conversion element (PD7), and a pixel including an eighth photoelectric conversion element (PD8).

In some implementations, the multi-pixel (MPX) may include a first photoelectric conversion element (PD1) connected to a first electrode of the split transistor (SPX) through the first transfer transistor (TX1), second to eighth photoelectric conversion elements (PD2~PD8) connected to a second electrode (ET) of the split transistor (SPX) through the second to eighth transfer transistors (TX2~TX8), a capacitor (C) for increasing capacitance of a floating diffusion region (FD), and a DCG transistor (DCX) connected between the capacitor (C) and the first electrode and controlling the capacitance of the floating diffusion region (FD) for accumulating photocharges generated by the second to eighth photoelectric conversion elements (PD2~PD8). In one example, the first electrode may correspond to a point where the split transistor (SPX) and the floating diffusion region (FD) are connected to each other.

In some implementations, the split transistor (SPX) may be turned on or off based on a split control signal (SPG). In one example, the HDR controller 300 may transmit a control signal to the timing controller 170, and the timing controller 170 may transmit a split control signal (SPG) of a logic high level or a logic low level to the split transistor (SPX) based on the control signal.

In one embodiment, the HDR controller 300 may transmit a control signal to the timing controller 170 to turn on the split transistor (SPX) based on the image signal processor (ISP) 200 detecting the low-illuminance environment, and may transmit a control signal to the timing controller 170 to turn on the split transistor (SPX) based on the image signal processor (ISP) 200 detecting the high-illuminance environment. In one example, the image signal processor (ISP) 200 may vary an analog gain mode based on the high-illuminance environment or the low-illuminance environment. In addition, the split transistor (SPX) may be turned on or off according to the analog gain mode.

In some implementations, the photoelectric conversion element (PD) may generate and accumulate photocharges corresponding to the intensity of incident light through photoelectric conversion of incident light. For example, the photoelectric conversion element (PD) may be implemented as a photodiode, a phototransistor, a photogate, a pinned photodiode, or a combination thereof. In some implementations, when the photoelectric conversion element (PD) is implemented as a photodiode, the photoelectric conversion element (PD) may be a region doped with impurities of a second conductivity type (e.g., N-type) in a substrate having a first conductivity type (e.g., P-type).

In some implementations, the first photoelectric conversion element (PD1) may have a lower light transmittance than the second to eighth photoelectric conversion elements (PD2~PD8). In one example, a pixel structure including the first photoelectric conversion element (PD1) may include a light blocking structure that blocks at least a portion of incident light. For example, the first pixel including the first photoelectric conversion element (PD1) may further include a microlens, an optical filter, a light blocking structure, and a substrate in addition to the first photoelectric conversion element (PD1). For example, the first pixel including the first photoelectric conversion element PD1 may further include, in addition to the first photoelectric conversion element PD1, a microlens, an optical filter, a light blocking structure, and a substrate.

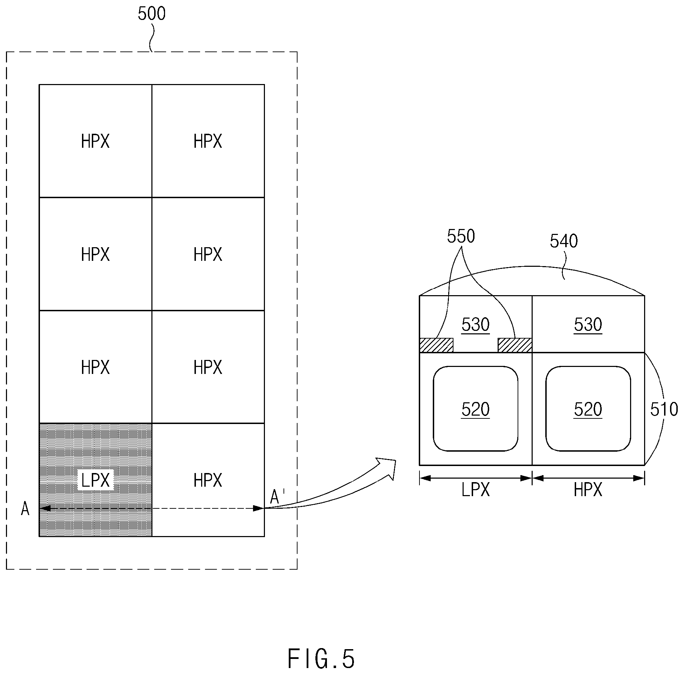

In some implementations, the second photoelectric conversion element (PD2) may have a higher light transmittance than the first photoelectric conversion element (PD1). In one example, a pixel structure including the second photoelectric conversion element (PD2) may not include a light blocking structure that blocks at least a portion of incident light, unlike the first photoelectric conversion element (PD1). For example, the second pixel including the second photoelectric conversion element (PD2) may further include a microlens, an optical filter, and a substrate in addition to the second photoelectric conversion element (PD2). In one example, the third to eighth photoelectric conversion elements (PD3~PD8) may be understood in the same manner as the second photoelectric conversion element (PD2). For example, each of the third to eighth photoelectric conversion elements (PD3~PD8) may have a higher light transmittance than the first photoelectric conversion element (PD1). For example, each of the third to eighth photoelectric conversion elements (PD3~PD8) may correspond to the same or similar light transmittance as the second photoelectric conversion element (PD2). A more detailed description of the light transmittance is provided herein below with reference to FIG. 5.

In some implementations, the first transfer transistor (TX1) may be connected between the first photoelectric conversion element (PD1) and the floating diffusion region (FD). In addition, the second to eighth transfer transistors (TX2~TX8) may be connected between the split transistor (SPX) and the second to eighth photoelectric conversion elements (PD2~PD8). The transfer transistors (TX1~TX8) may be turned on or off in response to the transfer signals (TG1~TG8), and the turned-on transfer transistors (TX1~TX8) may transfer photocharges accumulated in the photoelectric conversion elements (PD1~PD8) to the floating diffusion region (FD). For example, when the split transistor (SPX) is turned on, the turned-on second to eighth transfer transistors (TX2~TX8) may transfer photocharges accumulated in the second to eighth photoelectric conversion elements (PD2~PD8) to the floating diffusion region (FD).

In some implementations, the first to eighth transfer transistors (TX1~TX8) may be turned on or off based on the first to eighth transfer signals (TG1~TG8), respectively. In one example, the HDR controller 300 may transmit a control signal to the timing controller 170, and the timing controller 170 may transmit the first to eighth transfer signals (TG1~TG8) of a logic high level or a logic low level to the first to eighth transfer transistors (TX1~TX8) based on the control signal.

In some implementations, the drain transistor (DX) may be connected between the power-supply voltage (VDD) terminal and the second to eighth transfer transistors (TX2~TX8). In one example, when overflow charges are generated by the second to eighth photoelectric conversion elements (PD2~PD8) due to entrance of excessively bright light or occurrence of the crosstalk phenomenon, the drain transistor (DX) may be turned on to discharge the overflow charges generated by the second to eighth photoelectric conversion elements (PD2~PD8).

In some implementations, the drain transistor (DX) may be turned on or off based on a drain control signal (DG). In one example, the HDR controller 300 may transmit a control signal to the timing controller 170, and the timing controller 170 may transmit a drain control signal (DG) of a logic high level or a logic low level to the drain transistor (DX) based on the control signal. In one example, the HDR controller 300 may control the drain transistor (DX) to be turned on based on activation of the overflow detector 310 that detects photocharges greater than a threshold value within one or more second pixels.

In some implementations, the split transistor (SPX) may be connected between the first transfer transistor (TX1) and the second to eighth transfer transistors (TX2~TX8). In one example, the split transistor (SPX) may be turned on or off with a time difference to distinguish between a time point when photocharges generated by the first photoelectric conversion element (PD 1) are accumulated in the floating diffusion region (FD) and another time point when photocharges generated by the second to eighth photoelectric conversion elements (PD2~PD8) are accumulated in the floating diffusion region (FD). For example, when the split transistor (SPX) is turned off, the first transfer transistor (TX1) is turned on, so that photocharges accumulated in the first photoelectric conversion element (PD1) may be transferred to the floating diffusion region (FD). At this time, a pixel signal generated by the multi-pixel (MPX) may correspond to pixel data of the first pixel. For example, when the first transfer transistor (TX1) is turned off, the split transistor (SPX) and the second to eighth transfer transistors (TX2~TX8) are turned on, so that the photocharges accumulated in the second to eighth photoelectric conversion elements (PD2~PD8) can be transferred to the floating diffusion region (FD). At this time, the pixel signal generated by the multi-pixel (MPX) may correspond to pixel data of one or more second pixels.

In some implementations, the reset transistor (RX) may be connected between the power-supply voltage (VDD) terminal and the DCG transistor (DCX). In one example, the reset transistor (RX) may reset the voltage of the floating diffusion region (FD) to the power-supply voltage (VDD) in response to a reset control signal (RG) when the DCG transistor (DCX) is turned on in response to the DCG control signal (DCG). In one example, the power-supply voltage (VDD) may correspond to a preset value.

In some implementations, the reset transistor (RX) may be turned on or off based on the reset control signal (RG). In one example, the reset transistor (RX) may transmit a control signal to the timing controller 170, and the timing controller 170 may transmit a reset control signal (RG) of a logic high level or a logic low level to the reset transistor (RX) based on the control signal.

In some implementations, the floating diffusion region (FD) may accumulate photocharges received from the transfer transistors (TX1~TX8). The floating diffusion region (FD) may be connected to the capacitor (C) through the DCG transistor (DCX). For example, the floating diffusion region (FD) may be a region doped with impurities of a second conductivity type (e.g., N-type) in a substrate having a first conductivity type (e.g., P type). In one example, the capacitor (C) may include at least one of a Metal-Insulator-Metal (MIM) capacitor, a Metal-Insulator-Polysilicon (MIP) capacitor, a Metal-Oxide-Semiconductor (MOS) capacitor, and a junction capacitor.

In some implementations, the floating diffusion region (FD) may accumulate photocharges generated by the first photoelectric conversion element (PD1) when the first transfer transistor (TX1) is turned on and the split transistor (SPX) is turned off. In one example, when the first transfer transistor (TX1) is turned off and the split transistor (SPX) is turned on, the second to eighth transfer transistors (TX2~TX8) are turned on, so that the floating diffusion region (FD) may accumulate photocharges generated by the second to eighth photoelectric conversion elements (PD2~PD8).

In some implementations, the DCG transistor (DCX) may be connected between the floating diffusion region (FD) and the capacitor (C), and may selectively connect the capacitor (C) to the floating diffusion region (FD) in response to a DCG control signal (DCG). In one example, when the DCG transistor (DCX) is turned on, the floating diffusion region (FD) may have an increased capacitance compared to when the DCG transistor (DCX) is turned off. That is, the DCG transistor (DCX) may control the capacitance of the floating diffusion region (FD). In one example, although FIG. 3A illustrates an example case where there is one DCG transistor (DCX), other implementations are also possible, and it should be noted that multiple DCG transistors may also be used according to another embodiment. In that instance, the capacitance of the floating diffusion region (FD) may have a wider range of values.

In some implementations, the capacitor (C) may be connected between the power-supply voltage (VDD) terminal and the DCG transistor (DCX). In one example, when overflow charges are generated by the first photoelectric conversion element (PD1) due to entrance of excessively bright light or occurrence of the crosstalk phenomenon, the capacitor (C) may accumulate the generated overflow charges. For example, when the split transistor (SPX) is turned off, the DCG transistor (DCX) is turned on, and the reset transistor (RX) is turned off, the overflow charges generated by the first photoelectric conversion element (PD1) may be accumulated in the capacitor (C).

In some implementations, the capacitor (C) may be selectively connected to the floating diffusion region (FD) as the DCG transistor (DCX) is turned on or off. In one example, when the DCG transistor (DCX) is turned off, the floating diffusion region (FD) may have a reduced capacitance compared to when the DCG transistor (DCX) is turned on.

In some implementations, the source follower transistor (SF) may be connected between the power-supply voltage (VDD) terminal and the selection transistor (SX), may amplify a change in electric potential of the floating diffusion region (FD) that receives photocharges accumulated in the first to eighth photoelectric conversion elements (PD 1~PD8), and may transfer the amplified change to the selection transistor (SX).

In some implementations, the selection transistor (SX) may be connected between the source follower transistor (SF) and the output signal line, may be turned on by a selection control signal (SEL), and may output an electrical signal received from the source follower transistor (SF) as a pixel signal (PS).

In some implementations, the selection transistor (SX) may be turned on or off based on the selection control signal (SEL). In one example, the selection transistor (SX) may transmit a control signal to the timing controller 170, and the timing controller 170 may transmit a selection control signal (SEL) of a logic high level or a logic low level to the selection transistor (SX) based on the control signal.

Referring to FIG. 3B, the second multi-pixel (MPX2) may be one of the pixel groups each including one or more pixels included in the pixel array 110. Although FIG. 3B illustrates one second multi-pixel (MPX2) for convenience of description, other pixel groups may also have substantially the same structure and operation as the second multi-pixel (MPX2).

In some implementations, the second multi-pixel (MPX2) may include photoelectric conversion elements (PD1~PD4), transfer transistors (TX1~TX4), a drain transistor (DX), a split transistor (SPX), a reset transistor (RX), a floating diffusion region (FD), a DCG transistor (DCX), a capacitor (C), a source follower transistor (SF), and a selection transistor (SX). In FIG. 3B, although the second multi-pixel (MPX2) is illustrated as including four photoelectric conversion elements (PD1~PD4), other implementations are also possible, and it should be noted that the second multi-pixel (MPX2) according to another embodiment may also have a structure having two photoelectric conversion elements. For example, the second multi-pixel (MPX2) may not include the third photoelectric conversion element (PD3), the third transfer transistor (TX3), the fourth photoelectric conversion element (PD4), and the fourth transfer transistor (TX4) as applicable to particular implementations.

In some implementations, the second multi-pixel (MPX2) may include a first photoelectric conversion element (PD1) that is connected to a first electrode of the split transistor (SPX) through a first transfer transistor (TX1) and corresponds to a low light transmittance; second to fourth photoelectric conversion elements (PD2~PD4) that are connected to a second electrode (ET) of the split transistor (SPX) through the second to fourth transfer transistors (TX2~TX4) and correspond to a high light transmittance; a capacitor (C) capable of accommodating overflow charges of the first photoelectric conversion element (PD 1) corresponding to a low light transmittance; and a DCG transistor (DCX) that is connected between the capacitor (C) and the first electrode and controls the capacitance of the floating diffusion region (FD) that accumulates photocharges generated by the second to fourth photoelectric conversion elements (PD2~PD4) corresponding to a high light transmittance. In one example, the first electrode may correspond to a point where the split transistor (SPX) and the floating diffusion region (FD) are connected to each other.

In some implementations, the photoelectric conversion elements (PD1~PD4) may generate and accumulate photocharges corresponding to the intensity of incident light through photoelectric conversion of incident light. For example, each of the photoelectric conversion elements (PD1~PD4) may be implemented as a photodiode, a phototransistor, a photogate, a pinned photodiode, or a combination thereof. In some implementations, when each of the photoelectric conversion elements (PD1~PD4) is implemented as a photodiode, the photoelectric conversion element (PD) may be a region doped with impurities of a second conductivity type (e.g., N-type) in a substrate having a first conductivity type (e.g., P-type).

In some implementations, the first photoelectric conversion element (PD1) may correspond to a lower light transmittance than the second to fourth photoelectric conversion elements (PD2~PD4). In one example, the pixel structure including the first photoelectric conversion element (PD 1) may include a light blocking structure that blocks at least a portion of incident light. For example, the pixel structure including the first photoelectric conversion element (PD1) may further include a microlens, an optical filter, a light blocking structure, and a substrate in addition to the first photoelectric conversion element (PD1).

In some implementations, the second photoelectric conversion element (PD2) may correspond to a higher light transmittance than the first photoelectric conversion element (PD1). In one example, the pixel structure including the second photoelectric conversion element (PD2) may not include a light blocking structure that blocks at least a portion of incident light, unlike the first photoelectric conversion element (PD1). For example, the pixel structure including the second photoelectric conversion element (PD2) may further include a microlens, an optical filter, and a substrate, in addition to the second photoelectric conversion element (PD2). In one example, the third and fourth photoelectric conversion elements (PD3, PD4) may be understood similarly to the second photoelectric conversion element (PD2). For example, the third and fourth photoelectric conversion elements (PD3, PD4) may correspond to a higher light transmittance than the first photoelectric conversion element (PD1). For example, the third and fourth photoelectric conversion elements (PD3, PD4) may correspond to the same or similar light transmittance as the second photoelectric conversion element (PD2). A more detailed description of the light transmittance will be given later with reference to FIG. 5.

In some implementations, the multi-pixel (MPX) of FIG. 3B may correspond to the structure in which the fifth to eighth photoelectric conversion elements (PD5~PD8) and the fifth to eighth transfer transistors (TX5~TX8) are omitted from the multi-pixel (MPX) of FIG. 3A. In one example, the first to fourth transfer transistors (TX1~TX4), the drain transistor (DX), the split transistor (SPX), the reset transistor (RX), the floating diffusion region (FD), the DCG transistor (DCX), the capacitor (C), the source follower transistor (SF), and the selection transistor (SX) of FIG. 3B may be understood in the same manner as in FIG. 3A. Hereinafter, descriptions overlapping with those in FIG. 3A may be omitted.

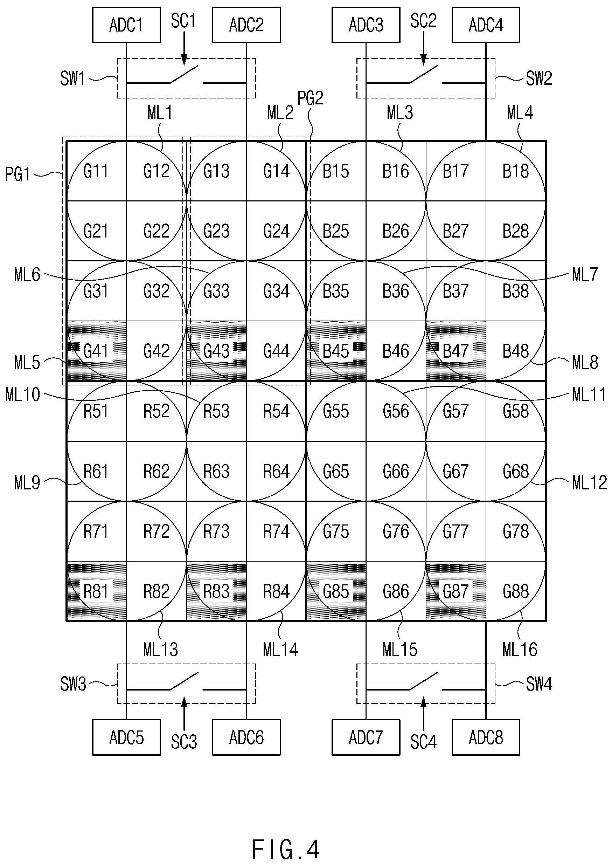

FIG. 4 is a diagram illustrating a pixel group, a plurality of microlenses, a plurality of ADCs, and a plurality of pixels corresponding thereto according to an embodiment of the present disclosure.

Referring to FIG. 4, the image sensing device 100 may correspond to an A4C (all 4-coupled) type sensor. In one example, the A4C sensor may detect a phase difference while simultaneously acquiring a color image from all pixels. In one example, the A4C sensor may include a form in which pixels (e.g., G11, G12, G21, G22) arranged in a (2 × 2) matrix structure share one microlens (e.g., ML1). In one example, the centers of the pixels (e.g., G11, G12, G21, G22) sharing the microlens (e.g., ML1) may be located at the same distance from the center of the microlens (e.g., ML1) shared by the pixels (e.g., G11, G12, G21, G22). Additional microlens ML2 to ML16 corresponding to further (2 x2) matrix structures are illustrated. Each of the microlens (e.g., ML1~ML16) may correspond to pixels in a (2 x2) matrix structure.

In some implementations, the pixels included in the pixel array 110 may be divided into two green filter regions, one blue filter region, and one red filter region, and may be arranged in a Bayer pattern. In one example, the pixels included in the pixel array 110 may form a unit Bayer pattern for every (8 × 8) pixels. For example, among the pixels included in the unit Bayer pattern, the (4 × 4) pixels (G11, G12, G13, G14, G21, G22, G23, G24, G31, G32, G33, G34, G41, G42, G43, G44) located at the upper left side and the (4 × 4) pixels (G55, G56, G57, G58, G65, G66, G67, G68, G75, G76, G77, G78, G85, G86, G87, G88) located at the lower right side may correspond to green filters, and the (4 × 4) pixels (B15, B16, B17, B18, B25, B26, B27, B28, B35, B36, B37, B38, B45, B46, B47, B48) located at the upper right side may correspond to blue filters, and the (4 × 4) pixels (R51, R52, R53, R54, R61, R62, R63, R64, R71, R72, R73, R74, R81, R82, R83, R84) located at the lower left side may correspond to red filters.

In some implementations, among the pixels included in the pixel array 110 of the image sensing device 100, pixels corresponding to eight identical color filters may be grouped into one pixel group (e.g., PG1 or PG2) in a column shape. In one example, the eight pixels may include seven pixels corresponding to a high light transmittance and one pixel corresponding to a low light transmittance. In one example, one pixel group (e.g., PG1 or PG2) may be connected to one corresponding ADC (e.g., ADC1 or ADC2), and the connected ADC may receive pixel signals (PS) of eight pixels included in the pixel group. In one example, the CDS circuit 130 may be connected between the pixel array 110 and the ADC (e.g., ADC1~ADC8), but the CDS circuit 130 may be omitted in FIG. 4 for convenience of description.

In some implementations, a first pixel group (PG1) of the pixel array 110 may include pixels (G11, G12, G21, G22, G31, G32, G41, G42) corresponding to eight identical color filters. In one example, the eight pixels (G11, G12, G21, G22, G31, G32, G41, G42) included in the first pixel group (PG1) may be divided into seven pixels (G11, G12, G21, G22, G31, G32, G42) corresponding to a high light transmittance and one pixel (G41) corresponding to a low light transmittance. In one example, referring to FIG. 3A together, seven pixels (G11, G12, G21, G22, G31, G32, G42) corresponding to a high light transmittance may include the second to eighth photoelectric conversion elements (PD2~PD8) of FIG. 3A, respectively, and one pixel (G41) corresponding to a low light transmittance may include the first photoelectric conversion element (PD1) of FIG. 3A.

In some implementations, the first pixel group (PG1) may include the first microlens (ML1) and the fifth microlens (ML5). The first microlens (ML1) may correspond to four pixels (G11, G12, G21, G22) corresponding to a high light transmittance, and the fifth microlens (ML5) may correspond to one pixel (G41) corresponding to a low light transmittance and three pixels (G31, G32, G42) corresponding to a high light transmittance. In one example, the first ADC (ADC1) may be connected to the first pixel group (PG1) to receive a pixel signal generated by the first pixel group (PG1). In one example, the first ADC (ADC1) may receive a pixel signal in which pixel signals of seven pixels (G11, G12, G21, G22, G31, G32, G42) corresponding to a high light transmittance are summed. The image signal processor (ISP) 200 may calculate pixel data of a low-illuminance image based on the summed pixel signal.

In some implementations, the second pixel group (PG2) of the pixel array 110 may include pixels (G13, G14, G23, G24, G33, G34, G43, G44) corresponding to eight identical color filters. In one example, the eight pixels (G13, G14, G23, G24, G33, G34, G43, G44) included in the second pixel group (PG2) may be divided into seven pixels (G13, G14, G23, G24, G33, G34, G44) corresponding to a high light transmittance and one pixel (G43) corresponding to a low light transmittance.

In some implementations, the second pixel group (PG2) may include a second microlens (ML2) and a sixth microlens (ML6). The second microlens (ML2) may correspond to four pixels (G13, G14, G23, G24) corresponding to a high light transmittance, and the sixth microlens (ML6) may correspond to one pixel (G43) corresponding to a low light transmittance and three pixels (G33, G34, G44) corresponding to a high light transmittance. In one example, the second ADC (ADC2) may be connected to the second pixel group (PG2) to receive a pixel signal generated by the second pixel group (PG2). In one example, the second ADC (ADC2) may receive a pixel signal in which pixel signals of seven pixels (G13, G14, G23, G24, G33, G34, G44) corresponding to a high light transmittance are summed. The image signal processor (ISP) 200 may calculate pixel data of a low-illuminance image based on the summed pixel signal.

In some implementations, for the remaining pixels, pixels corresponding to eight identical color filters may be grouped into one pixel group and connected to one ADC (e.g., ADC3, ADC4, ADC5, ADC6, ADC7, or ADC8), and as such redundant description thereof will herein be omitted for brevity.

In some implementations, a pixel receiver of the first ADC (ADC 1) and a pixel receiver of the second ADC (ADC2) may be selectively connected to each other by a first switch (SW1). In one example, the first switch (SW1) may be opened or closed based on a first switch control signal (SC1). In one example, when the first switch (SW1) is opened, the first ADC (ADC1) may receive a pixel signal from the first pixel group (PG1). In addition, the second ADC (ADC2) may receive a pixel signal from the second pixel group (PG2). For example, when the first switch (SW1) is opened, the first ADC (ADC1) may receive pixel signals of seven pixels (G11, G12, G21, G22, G31, G32, G42) corresponding to a high light transmittance and/or a pixel signal of one pixel (G41) corresponding to a low light transmittance from the first pixel group (PG1). In addition, the second ADC (ADC2) may receive pixel signals of seven pixels (G13, G14, G23, G24, G33, G34, G44) corresponding to a high light transmittance and/or a pixel signal of one pixel (G43) corresponding to a low light transmittance from the second pixel group (PG2).

In some implementations, when the first switch (SW1) is closed, the first ADC (ADC1) or the second ADC (ADC2) may receive a signal in which pixel signals of seven pixels (G11, G12, G21, G22, G31, G32, G42) corresponding to a high light transmittance of the first pixel group (PG1) and pixel signals of other seven pixels (G13, G14, G23, G24, G33, G34, G44) corresponding to a high light transmittance of the second pixel group (PG2) are summed. In addition, the first ADC (ADC1) or the second ADC (ADC2) may receive a signal in which a pixel signal of one pixel (G41) corresponding to a low light transmittance of the first pixel group (PG1) and a pixel signal of one pixel (G43) corresponding to a low light transmittance of the second pixel group (PG2) are summed. In one example, when the first switch (SW1) is closed, one of the first ADC (ADC1) or the second ADC (ADC2) is deactivated, and a pixel signal can be received using the activated ADC. In one example, the imaging device 10 may drive the deactivated ADC in a low-power mode.

In some implementations, when the first switch (SW1) is closed, the pixel signal of the first pixel group (PG1) and the pixel signal of the second pixel group (PG2) are summed, so that the speed of generating image data (IDATA) using the pixel signal may increase. Conversely, when the first switch (SW1) is opened, the pixel signal of the first pixel group (PG1) and the pixel signal of the second pixel group (PG2) are processed separately from each other, so that resolution of the image data (IDATA) may be improved. In one example, when the image first switch (SW1) is closed, the image signal processor (ISP) 200 may calculate an average of the pixel signal of the first pixel group (PG1) and the pixel signal of the second pixel group (PG2), thereby reducing noise components of such pixel signals. The operations and effects of the second switch (SW2), the third switch (SW3), and the fourth switch (SW4) may also be understood in the same manner as the operations and effects of the first switch (SW1), and as such redundant descriptions thereof will herein be omitted for brevity.

In some implementations, the pixel array 110 may be arranged in a Bayer pattern, and pixels included in the pixel array 110 may form a unit Bayer pattern for every (4 × 4) pixels. For example, among the pixels included in the unit Bayer pattern, (2 × 2) pixels located at the upper left side and (2 × 2) pixels located at the lower right side may correspond to green filters, (2 × 2) pixels located at the upper right side may correspond to blue filters, and (2 × 2) pixels located at the lower left side may correspond to red filters.

In some implementations, among the pixels included in the pixel array 110 of the image sensing device 100, pixels corresponding to four identical color filters may be grouped into one pixel group. In one example, four pixels may include three pixels corresponding to a high light transmittance and one pixel corresponding to a low light transmittance. In one example, one pixel group may be connected to one ADC corresponding thereto, and the connected ADC may receive pixel signals (PS) of four pixels included in the pixel group. In one example, further referring also to FIG. 3B, among the four pixels together, three pixels corresponding to a high light transmittance may include the second to fourth photoelectric conversion elements (PD2~PD4) of FIG. 3B, respectively, and one pixel corresponding to a low light transmittance may include the first photoelectric conversion element (PD1) of FIG. 3B.

FIG. 5 is a cross-sectional view illustrating an example of a high-transmittance pixel and a low-transmittance pixel according to an embodiment of the present disclosure.

Referring to FIG. 5, an embodiment is illustrated on the left side of FIG. 5 in which a low-transmittance pixel (LPX) having a relatively low light transmittance and a high-transmittance pixel (HPX) having a relatively high light transmittance are arranged. That is, the configuration illustrated on the left side of FIG. 5 may correspond to a pixel group 500 in which one low-transmittance pixel (LPX) and seven high-transmittance pixels (HPXs) are arranged in a (4 × 2) matrix. In one example, the pixel group 500 may correspond to the multi-pixel (MPX) of FIG. 3A or the first pixel group (PG1) of FIG. 4. In one example, the low-transmittance pixel (LPX) of FIG. 5 may correspond to the first photoelectric conversion element (PD1) of FIG. 3A or one pixel (G41) corresponding to a low light transmittance of FIG. 4.

In some implementations, each of the low-transmittance pixel (LPX) and the plurality of high-transmittance pixels (HPX) may have a structure corresponding to FIG. 3A. In one example, each of the low-transmittance pixel (LPX) and the high-transmittance pixel (HPX) may independently include a photoelectric conversion element and a transfer transistor, whereas other components (e.g., a drain transistor DX, a split transistor SPX, a reset transistor RX, a floating diffusion region FD, a DCG transistor DCX, a capacitor C, a source follower transistor SF, and a selection transistor SX) may be implemented as a shared pixel structure shared by eight pixels. In one example, the low-transmittance pixel (LPX) and the high-transmittance pixel (HPX) may be pixels that sense light of the same color (e.g., red, blue, or green).

In some implementations, the right side of FIG. 5 illustrates a cross-sectional view of a low-transmittance pixel (LPX) and a high-transmittance pixel (HPX) (arranged adjacent to each other) taken along the line A-A' of FIG. 5 from among pixels included in a pixel group 500. In one example, the cross-section of the high-transmittance pixel (HPX) may include a substrate 510, a photoelectric conversion element 520, an optical filter 530, and a microlens 540, and the low-transmittance pixel (LPX) may further include a light blocking structure 550 as well as the above-described components.

In some implementations, the substrate 510 may be a semiconductor substrate. For example, the substrate 510 may be a P-type or N-type bulk substrate, may be a substrate formed by growing a P-type or N-type epitaxial layer on the P-type bulk substrate, or may be a substrate formed by growing a P-type or N-type epitaxial layer on the N-type bulk substrate.

In some implementations, the photoelectric conversion element 520 may be formed in the substrate 510, and may correspond to the photoelectric conversion element (PD) of FIGS. 3A and 3B. That is, the photoelectric conversion element 520 may generate and accumulate photocharges corresponding to the intensity of incident light having penetrated the microlens 540 and the optical filter 530.

In some implementations, the optical filters 530 may selectively transmit light (e.g., red light, green light, blue light, magenta light, yellow light, cyan light, infrared (IR) light, or the like) having a wavelength band to be transmitted. In this case, the wavelength band may refer to a wavelength band of light to be selectively transmitted by the corresponding optical filter. For example, each of the optical filters 530 may include a colored photosensitive material corresponding to a specific color, or may include thin film layers that are alternately arranged. The optical filters included in the pixel array 110 may be arranged to correspond to the pixels arranged in a matrix array including a plurality of rows and a plurality of columns, resulting in formation of an optical filter array.

In some implementations, each of the microlenses 540 may be formed over each of the optical filters 530, and may increase light gathering power of incident light, resulting in increased light reception (Rx) efficiency of the photoelectric conversion element 520.

In some implementations, the light blocking structure 550 may be disposed between one surface of the substrate 510 and the optical filter 530, so that at least a portion of incident light that has penetrated the optical filter 530 in the low-transmittance pixel (LPX) is blocked by the light blocking structure 550 without being transferred to the photoelectric conversion element 520. The light blocking structure 550 may include at least one of a material having high light reflectivity (e.g., silver, aluminum) and a material having a high light absorption rate (high absorptivity) (e.g., tungsten). For example, the light blocking structure 550 may include a half-shield structure, a neutral-density (ND) filter, or a gray filter.

In some implementations, the total area of the low-transmittance pixel (LPX) may be defined as the sum of an opened area of a region where the light blocking structure 550 is not disposed and a blocked area of a region where the light blocking structure 550 is disposed. Light transmittance of the low-transmittance pixel (LPX) may be determined according to a ratio between the blocked area and the opened area.

In some implementations, the high-transmittance pixel (HPX) not including the light blocking structure 550 may have a higher light transmittance than the low-transmittance pixel (LPX) including the light blocking structure 550. That is, when incident light having the same intensity is incident upon the high-transmittance pixel (HPX) and the low-transmittance pixel (LPX), the intensity of light transferred to the photoelectric conversion element 520 of the low-transmittance pixel (LPX) may be less than the intensity of light transferred to the photoelectric conversion element 520 of the high-transmittance pixel (HPX).

In addition, the intensity of light transferred to the photoelectric conversion element 520 of the low-transmittance pixel (LPX) may increase with a relatively lower slope in response to the increasing intensity of incident light. The intensity of light transferred to the photoelectric conversion element 520 of the high-transmittance pixel (HPX) may increase with a relatively higher slope in response to the increasing intensity of incident light.

In some implementations, since each of the intensity of light transferred to the photoelectric conversion element 520 of the low-transmittance pixel (LPX) and the intensity of light transferred to the photoelectric conversion element 520 of the high-transmittance pixel (HPX) is converted into a pixel signal, the response of the low-transmittance pixel (LPX) may follow the response of the low-sensitivity pixel shown in FIG. 2, and the response of the high-transmittance pixel (HPX) may follow the response of the high-sensitivity pixel shown in FIG. 2.

In some implementations, although the light blocking structure 550 shown in FIG. 5 is disposed at the edge of the low-transmittance pixel (LPX), other implementations are also possible. For example, the light blocking structure 550 may be disposed at any location of the low-transmittance pixel (LPX), and the light blocking structure 550 may also be disposed in the entire region of the low-transmittance pixel (LPX) in a situation where some parts of the light blocking structure 550 are not opened.

In some implementations, the image sensing device 100 can simultaneously implement the low-sensitivity pixel and the high-sensitivity pixel within only one pixel array 110, and can thus form (or generate) the HDR image using only one image.

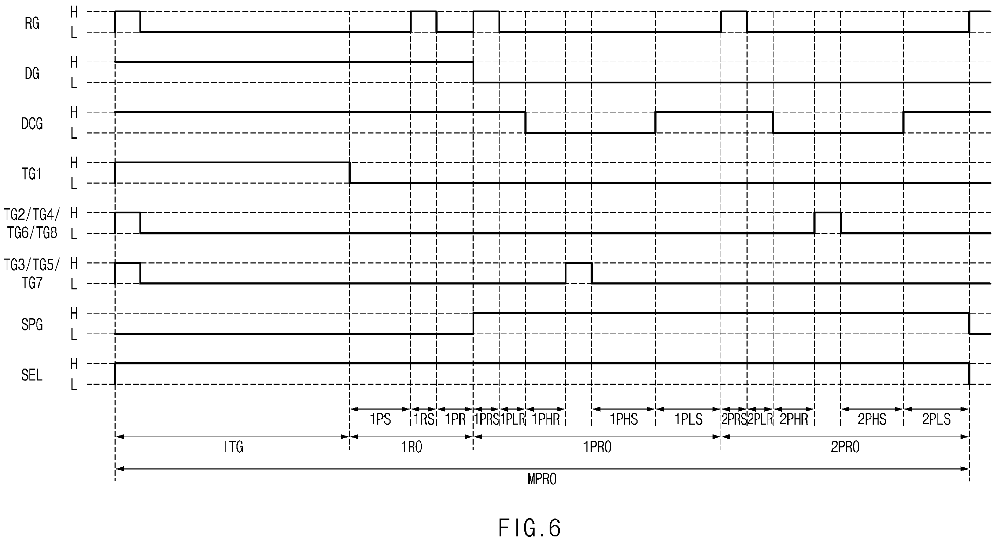

FIG. 6 is a timing diagram illustrating example operations of constituent elements included in the circuit diagram of FIG. 3A according to an embodiment of the present disclosure.

Referring to FIG. 6, each component of the multi-pixel (MPX) corresponding to one pixel group of the pixel array 110 may receive a reset control signal (RG), a drain control signal (DG), a DCG control signal (DCG), first to eighth transfer signals (TG1~TG8), a split control signal (SPG), and a selection control signal (SEL). In one example, each of the constituent components of the multi-pixel (MPX) may be turned on when the signal received by each component is at a logic high level (H), and may be turned off when the signal received by each component is at a logic low level (L). For example, each of the reset control signal (RG), the drain control signal (DG), the DCG control signal (DCG), the first to eighth transfer signals (TG1~TG8), the split control signal (SPG), and the selection control signal (SEL) may have a logic low level (L) and a logic high level (H), a transistor to which a signal having a logic low level (L) is input may be turned off, and a transistor to which a signal having a logic high level (H) is input may be turned on.

In some implementations, the operation of the multi-pixel (MPX) may be performed during a multi-pixel readout period (MPRO). In one example, a first phase may correspond to a left phase, and a second phase may correspond to a right phase. In one example, the HDR controller 300 may divide the operation period of the multi-pixel (MPX) into a plurality of operation sections so that the pixels of the image sensing device 100 may have an optimal dynamic range, and may control signals to be input to each of the constituent elements of the multi-pixel (MPX). For example, the HDR controller 300 may control the timing controller 170 of the image sensing device 100.

In some implementations, the multi-pixel readout period (MPRO) may include a summation period (ITG), a first readout period (1RO), a first phase readout period (1PRO), and a second phase readout period (2PRO). In one example, referring to FIG. 3A together, the selection control signal (SEL) may be at a logic high level (H) during the multi-pixel readout period (MPRO). In one example, the pixel array 110 may be driven row by row by the row driver 120. Accordingly, the multi-pixel readout period (MPRO) may correspond to a period in which a row corresponding to a multi-pixel (MPX) among the pixel array 110 is selected and a pixel signal generated by the multi-pixel (MPX) is read out.

In some implementations, the summation period (ITG) may include a period for resetting photocharges accumulated in all photoelectric conversion elements included in the multi-pixel (MPX) before reading out the pixel signal. For example, the summation period

(ITG) may include a period in which the reset control signal (RG), the drain control signal (DG), the DCG control signal (DCG), and the first to eighth transfer signals (TG1~TG8) are at a logic high level (H). In addition, the split control signal (SPG) may be at a logic low level (L) in the summation period (ITG).

In some implementations, the summation period (ITG) may include a period for transferring photocharges accumulated in the first photoelectric conversion element (PD1) to the floating diffusion region (FD). For example, the summation period (ITG) may transfer the photocharges accumulated in the first photoelectric conversion element (PD1) to the floating diffusion region (FD) during a time section in which the first transfer signal (TG1) and the DCG control signal (DCG) are at a logic high level (H). At this time, since the DCG control signal (DCG) is at a logic high level, the capacitance of the floating diffusion region (FD) may increase by the capacitor (C). In one example, when the first photoelectric conversion element (PD1) receives bright light and overflow charges are generated, the DCG control signal (DCG) is at a logic high level, so that overflow charges of the first photoelectric conversion element (PD1) may be accumulated in the capacitor (C). In one example, when the second to eighth photoelectric conversion elements (PD2~PD8) receive bright light and overflow charges are generated, the drain control signal (DG) is at a logic high level, so that the overflow charges of the second to eighth photoelectric conversion elements (PD2~PD8) may be discharged by the power-supply voltage (VDD).

In some implementations, the first readout period (1RO) may include a first pixel signal period (1PS), a reset period (1RS), and a first reset signal period (1PR). Referring also to FIG. 3A, during the first readout period (1RO), the split control signal (SPG) may be at a logic low level (L). Therefore, the first readout period (1RO) may correspond to a period in which the pixel signal is generated based on the photocharges generated by the first photoelectric conversion element (PD1).

In some implementations, during the first pixel signal period (1PS), the multi-pixel (MPX) may generate an electrical signal corresponding to photocharges generated by the first photoelectric conversion element (1PD) and may output the generated electrical signal as a first pixel signal. For example, during the first readout period (1RO), a time section from a time point at which the first transfer signal (TG1) transitions from a logic high level (H) to a logic low level (L) to another time point at which the reset control signal (RG) transitions from a logic low level (L) to a logic high level (H), may be denoted by a first pixel signal period (1PS). For example, the first pixel signal period (1PS) may be a time period in which an electrical signal corresponding to the photocharges accumulated in the floating diffusion region (FD) is output as a first pixel signal during a preset period from among the summation period (ITG). Here, the preset period may range from a time point at which the first transfer signal (TG1) transitions from a logic low level (L) to a logic high level (H) to another time point at which the first transfer signal (TG1) transitions from a logic high level (H) to a logic low level (L).

In some implementations, during the reset period (1RS), the multi-pixel (MPX) may remove the photocharges remaining in each of the first photoelectric conversion element and the multi-pixel (MPX), and may reset the floating diffusion region (FD) to the power-supply voltage (VDD). For example, during the first readout period (1RO), a preset period from a time point at which the reset control signal (RG) transitions from the logic low level (L) to the logic high level (H) to another time point at which the reset control signal (RG) transitions from the logic high level (H) to the logic low level (L) may correspond to the reset period (1RS).

In some implementations, during the first reset signal period (1PR), the multi-pixel (MPX) may output the first reset signal when the first photoelectric conversion element (1PD) and the floating diffusion region (FD) are in a reset state. For example, during the first readout period (1RO), a preset period from a time point at which the reset control signal (RG) transitions from a logic high level (H) to a logic low level (L) to another time point at which the reset control signal (RG) transitions from a logic low level (L) to a logic high level (H) may correspond to a first reset signal period (1PR). For example, the first reset signal period (1PR) may be a period in which, in a reset state, an electrical signal corresponding to photocharges accumulated in the floating diffusion region (FD) is output as the first reset signal.

In some implementations, each of the first pixel signal and the first reset signal generated during the first readout period (1RO) may be converted into a digital value of a pixel signal corresponding to the first readout period (1RO) through the CDS circuit 130 and the ADC 140.

In some implementations, the first readout period (1RO) may correspond to a period in which a pixel signal is generated based on photocharges generated by the first photoelectric conversion element (PD1) corresponding to a relatively low light transmittance. That is, when incident light of the same intensity is incident upon the first photoelectric conversion element (PD1) and the second to eighth photoelectric conversion elements (PD2~PD8), the quantity of photocharges of the first photoelectric conversion element (PD1) accumulated in the floating diffusion region (FD) may be smaller than the quantity of photocharges of the second to eighth photoelectric conversion elements (PD2~PD8) accumulated in the floating diffusion region (FD).

In some implementations, the quantity of photocharges accumulated in the floating diffusion region (FD) of the first photoelectric conversion element (PD1) may increase with a relatively low slope in response to an increase in the intensity of incident light, and the quantity of photocharges accumulated in the floating diffusion regions (FD) of the second to eighth photoelectric conversion elements (PD2~PD8) to be described below may increase with a relatively high slope in response to an increase in the intensity of incident light.

In some implementations, referring also to FIG. 2, each of the quantity of photocharges accumulated in the floating diffusion region (FD) of the first photoelectric conversion element (PD1) and the quantity of photocharges accumulated in the floating diffusion region (FD) of the second to eighth photoelectric conversion elements (PD2~PD8) to be described later is converted into a pixel signal, so that the pixel signal corresponding to the first photoelectric conversion element (PD1) follows the response of the low-sensitivity pixel illustrated in FIG. 2, and the pixel signal corresponding to the second to eighth photoelectric conversion elements (PD2~PD8) to be described later follows the response of the high-sensitivity pixel illustrated in FIG. 2. The image sensing device 100 according to another embodiment of the present disclosure can simultaneously implement the low-sensitivity pixel and the high-sensitivity pixel within only one pixel array 110, and can thus form (or generate) the HDR image using only one image.

In some implementations, the first phase readout period (1PRO) may include a first phase reset period (1PRS), a first phase low conversion gain (LCG) reset signal period (1PLR), a first phase high conversion gain (HCG) reset signal period (1PHR), a first phase HCG pixel signal period (1PHS), and a first phase LCG pixel signal period (1PLS). Referring also to FIG. 3A, during the first phase readout period (1PRO), the split control signal (SPG) may be in a logic high level (H) state, and the first transfer signal (TG1), the second transfer signal (TG2), the fourth transfer signal (TG4), the sixth transfer signal (TG6), and the eighth transfer signal (TG8) may be in a logic low level (L) state. Accordingly, the first phase readout period (1PRO) may correspond to a period in which a pixel signal is generated based on photocharges generated by the third photoelectric conversion element (PD3), the fifth photoelectric conversion element (PD5), and the seventh photoelectric conversion element (PD7).

In some implementations, the first phase readout period (1PRO) may correspond to a time section for generating a pixel signal for generating a phase-difference image in a first direction. For example, the first direction may correspond to a left direction. In one example, referring also to FIG. 4, the multi-pixel (MPX) may correspond to the first pixel group (PG1), and the third photoelectric conversion element (PD3), the fifth photoelectric conversion element (PD5), and the seventh photoelectric conversion element (PD7) may correspond to a high-transmittance pixel (G31) located in a left region of the fifth microlens (ML5) and high-transmittance pixels (G21, G11) located in a left region of the first microlens (ML1), respectively. In one example, the image signal processor (ISP) 200 may generate a left-right phase difference image based on a left phase difference image and a right phase difference image, and may calculate a phase difference based on a disparity of the left-right phase difference image.

In some implementations, during the first phase reset period (1PRS), the multi-pixel (MPX) may remove photocharges remaining in the third photoelectric conversion element (PD3), the fifth photoelectric conversion element (PD5), the seventh photoelectric conversion element (PD7), and the multi-pixel (MPX), and may reset the floating diffusion region (FD) to the power-supply voltage (VDD). In one example, during the first phase readout period (1PRO), a preset period from a time point at which the reset control signal (RG) transitions from a logic low level (L) to a logic high level (H) to another time point at which the reset control signal (RG) transitions from a logic high level (H) to a logic low level (L) may correspond to the first phase reset period (1PRS).

In some implementations, during the first phase LCG reset signal period (1PLR), the multi-pixel (MPX) may output a first phase LCG reset signal which is a pixel signal when the third photoelectric conversion element (PD3), the fifth photoelectric conversion element (PD5), the seventh photoelectric conversion element (PD7), and the floating diffusion region (FD) are in a reset state. At this time, since the DCG control signal (DCG) is at a logic high level (H), the capacitance of the floating diffusion region (FD) may correspond to a state in which the capacitance is increased by the capacitor (C). For example, during the first phase readout period (1PRO), a preset period from a time point at which the reset control signal (RG) transitions from the logic high level (H) to the logic low level (L) to another time point at which the DCG control signal (DCG) transitions from the logic high level (H) to the logic low level (L) may correspond to the first phase LCG reset signal period (1PLR). For example, the first phase LCG reset signal period (1PLR) may be a time section in which, in the reset state, an electrical signal corresponding to photocharges accumulated in the floating diffusion region (FD) with increased capacitance is output as the first phase LCG reset signal.

In some implementations, during the first phase HCG reset signal period (1PHR), the multi-pixel (MPX) may output the first phase HCG reset signal which is a pixel signal when the third photoelectric conversion element (PD3), the fifth photoelectric conversion element (PD5), the seventh photoelectric conversion element (PD7), and the floating diffusion region (FD) are in the reset state. At this time, since the DCG control signal (DCG) is at a logic low level (L), capacitance of the floating diffusion region (FD) may correspond to a state in which the capacitance is reduced compared to the capacitance obtained when the DCG control signal (DCG) is at a logic high level (H). For example, during the first phase readout period (1PRO), a preset period from a time point at which the DCG control signal (DCG) transitions from a logic high level (H) to a logic low level (L) to another time point at which the third transfer signal (TG3), the fifth transfer signal (TG5), and the seventh transfer signal (TG7) transition from a logic low level (L) to a logic high level (H) may correspond to a first phase HCG reset signal period (1PHR). For example, the first phase HCG reset signal period (1PHR) may be a time section in which, in the reset state, an electrical signal corresponding to photocharges accumulated in the floating diffusion region (FD) with reduced capacitance is output as a first phase HCG reset signal.

In some implementations, during the first phase HCG pixel signal period (1PHS), the multi-pixel (MPX) may generate an electrical signal corresponding to the photocharges generated by the third photoelectric conversion element (PD3), the fifth photoelectric conversion element (PD5), and the seventh photoelectric conversion element (PD7), and may output the electrical signal as the first phase HCG pixel signal. At this time, since the DCG control signal (DCG) is at a logic low level (L), the capacitance of the floating diffusion region (FD) may correspond to a state in which the capacitance is reduced compared to a state in which the DCG control signal (DCG) is at a logic high level (H). For example, during the first phase readout period (1PRO), a preset period from a time point at which the third transfer signal (TG3), the fifth transfer signal (TG5), and the seventh transfer signal (TG7) transition from a logic high level (H) to a logic low level (L) to another time point at which the DCG control signal (DCG) transitions from a logic low level (L) to a logic high level (H) may correspond to a first phase HCG pixel signal period (1PHS). For example, the first phase HCG pixel signal period (1PHS) may be a time section in which an electrical signal corresponding to photocharges accumulated in the floating diffusion region (FD) with reduced capacitance is output as a first phase HCG pixel signal. At this time, the photocharges accumulated in the floating diffusion region (FD) may correspond to photocharges which are transferred to the floating diffusion region (FD) during a preset period from a time point at which the third transfer signal (TG3), the fifth transfer signal (TG5), and the seventh transfer signal (TG7) transition from a logic low level (L) to a logic high level (H) to another time point at which the third transfer signal (TG3), the fifth transfer signal (TG5), and the seventh transfer signal (TG7) transition from a logic high level (H) to a logic low level (L).

In some implementations, during the first phase LCG pixel signal period (1PLS), the multi-pixel (MPX) may generate an electrical signal corresponding to the photocharges generated by the third photoelectric conversion element (PD3), the fifth photoelectric conversion element (PD5), and the seventh photoelectric conversion element (PD7), and may output the electrical signal as the first phase LCG pixel signal. At this time, since the DCG control signal (DCG) is at a logic high level (H), capacitance of the floating diffusion region (FD) may correspond to a state in which the capacitance is increased by the capacitor (C). For example, during the first phase readout period (1PRO), a preset period from a time point at which the DCG control signal (DCG) transitions from a logic low level (L) to a logic high level (H) to another time point at which the reset control signal (RG) transitions from a logic low level (L) to a logic high level (H) may correspond to the first phase LCG pixel signal period (1PLS). For example, the first phase LCG pixel signal period (1PLS) may be a time section in which an electrical signal corresponding to photocharges accumulated in the floating diffusion region (FD) with increased capacitance is output as a first phase LCG pixel signal. At this time, the photocharges accumulated in the floating diffusion region (FD) may correspond to photocharges which are transferred to the floating diffusion region (FD) during a preset period from a time point at which the third transfer signal (TG3), the fifth transfer signal (TG5), and the seventh transfer signal (TG7) transition from a logic low level (L) to a logic high level (H) to another time point at which the third transfer signal (TG3), the fifth transfer signal (TG5), and the seventh transfer signal (TG7) transition from a logic high level (H) to a logic low level (L).

In some implementations, each of the first phase LCG reset signal and the first phase LCG pixel signal generated during the first phase readout period (1PRO) may be converted into a digital value of the first phase LCG signal (which is a pixel signal corresponding to the first phase readout period 1PRO) through the CDS circuit 130 and the ADC 140. In one example, each of the first phase HCG reset signal and the first phase HCG pixel signal generated during the first phase readout period (1PRO) may be converted into a digital value of the first phase HCG signal (which is a pixel signal corresponding to the first phase readout period 1PRO) through the CDS circuit 130 and the ADC 140.

In some implementations, during the first phase readout period (1PRO), photocharges accumulated in the floating diffusion region (FD) may generate a voltage change in the floating diffusion region (FD), and the voltage change in the floating diffusion region (FD) may be converted into an electrical signal by the source follower transistor (SF). At this time, the degree of voltage change of the floating diffusion region (FD) may be determined by the capacitance of the floating diffusion region (FD). For the same quantity of photocharges, the capacitance of the floating diffusion region (FD) is inversely proportional to the voltage change of the floating diffusion region (FD). That is, when the same quantity of photocharges is transferred from the third photoelectric conversion element (PD3), the fifth photoelectric conversion element (PD5), and the seventh photoelectric conversion element (PD7) to the floating diffusion region (FD), the magnitude of the first phase HCG signal when the DCG control signal is at a logic low level (L) may be greater than the magnitude of the first phase LCG signal when the DCG control signal is at a logic high level (H).

In some implementations, the magnitude of the first phase LCG signal when the DCG control signal is at a logic high level (H) increases with a relatively low slope in response to the increased quantity of photocharges, and the magnitude of the first phase HCG signal when the DCG control signal is at a logic low level (L) increases with a relatively high slope in response to the increased quantity of photocharges. In one example, referring also to FIG. 2, since each of the magnitude of the first phase LCG signal and the magnitude of the first phase HCG signal is converted into image data (IDATA), the response of the first phase LCG signal may follow the response of the low-sensitivity pixel illustrated in FIG. 2, and the response of the first phase HCG signal may follow the response of the high-sensitivity pixel illustrated in FIG. 2. In one example, the image sensing device 100 according to another embodiment of the present disclosure can simultaneously implement the low-sensitivity pixel and the high-sensitivity pixel within only one pixel array 110, and can thus form (or generate) the HDR image using only one image.

In some implementations, the second phase readout period (2PRO) may include a second phase reset period (2PRS), a second phase LCG reset signal period (2PLR), a second phase HCG reset signal period (2PHR), a second phase HCG pixel signal period (2PHS), and a second phase LCG pixel signal period (2PLS). Referring also to FIG. 3A, during the second phase readout period (2PRO), the split control signal (SPG) may be in a logic high level (H) state, and the first transfer signal (TG1), the third transfer signal (TG3), the fifth transfer signal (TG5), and the seventh transfer signal (TG7) may be in a logic low level (L) state. Accordingly, the second phase readout period (2PRO) may correspond to a time section in which a pixel signal is generated based on photocharges generated by the second photoelectric conversion element (PD2), the fourth photoelectric conversion element (PD4), the sixth photoelectric conversion element (PD6), and the eighth photoelectric conversion element (PD8).

In some implementations, the second phase readout period (2PRO) may correspond to a time section for generating a pixel signal for generating a phase difference image in a second direction. For example, the second direction may correspond to a right direction. In one example, referring also to FIG. 4, the multi-pixel (MPX) may correspond to the first pixel group (PG1), and the second photoelectric conversion element (PD2), the fourth photoelectric conversion element (PD4), the sixth photoelectric conversion element (PD6), and the eighth photoelectric conversion element (PD8) may correspond to high-transmittance pixels (G42, G43) located in a right region of the fifth microlens (ML5) and high-transmittance pixels (G22, G12) located in a right region of the first microlens (ML1), respectively. In one example, the image signal processor (ISP) 200 may generate a left-right phase difference image based on a left phase difference image and a right phase difference image, and may calculate a phase difference of the image based on a disparity of the left-right phase difference image.

In some implementations, during the second phase reset period (2PRS), the multi-pixel (MPX) may remove photocharges remaining in the second photoelectric conversion element (PD2), the fourth photoelectric conversion element (PD4), the sixth photoelectric conversion element (PD6), the eighth photoelectric conversion element (PD8), and the multi-pixel (MPX), and may reset the floating diffusion region (FD) to the power-supply voltage (VDD). In one example, during the second phase readout period (2PRO), a preset period from a time point at which the reset control signal (RG) transitions from a logic low level (L) to a logic high level (H) to another time point at which the reset control signal (RG) transitions from a logic high level (H) to a logic low level (L) may correspond to the second phase reset period (2PRS).

In some implementations, during the second phase LCG reset signal period (2PLR), the multi-pixel (MPX) may output a second phase LCG reset signal which is a pixel signal when the second photoelectric conversion element (PD2), the fourth photoelectric conversion element (PD4), the sixth photoelectric conversion element (PD6), the eighth photoelectric conversion element (PD8), and the floating diffusion region (FD) are in a reset state. At this time, since the DCG control signal (DCG) is at a logic high level (H), the capacitance of the floating diffusion region (FD) may correspond to a state in which the capacitance is increased by the capacitor (C). For example, during the second phase readout period (2PRO), a preset period from a time point at which the reset control signal (RG) transitions from the logic high level (H) to the logic low level (L) to another time point at which the DCG control signal (DCG) transitions from the logic high level (H) to the logic low level (L) may correspond to the second phase LCG reset signal period (2PLR). For example, the second phase LCG reset signal period (2PLR) may be a time section in which, in the reset state, an electrical signal corresponding to photocharges accumulated in the floating diffusion region (FD) with increased capacitance is output as the second phase LCG reset signal.

In some implementations, during the second phase HCG reset signal period (2PHR), the multi-pixel (MPX) may output the second phase HCG reset signal which is a pixel signal when the second photoelectric conversion element (PD2), the fourth photoelectric conversion element (PD4), the sixth photoelectric conversion element (PD6), the eighth photoelectric conversion element (PD8), and the floating diffusion region (FD) are in the reset state. At this time, since the DCG control signal (DCG) is at a logic low level (L), capacitance of the floating diffusion region (FD) may correspond to a state in which the capacitance is reduced compared to the capacitance obtained when the DCG control signal (DCG) is at a logic high level (H). For example, during the second phase readout period (2PRO), a preset period from a time point at which the DCG control signal (DCG) transitions from a logic high level (H) to a logic low level (L) to another time point at which the second transfer signal (TG2), the fourth transfer signal (TG4), the sixth transfer signal (TG6), and the eighth transfer signal (TG8) transition from a logic low level (L) to a logic high level (H) may correspond to a second phase HCG reset signal period (2PHR). For example, the second phase HCG reset signal period (2PHR) may be a time section in which, in the reset state, an electrical signal corresponding to photocharges accumulated in the floating diffusion region (FD) with reduced capacitance is output as a second phase HCG reset signal.

In some implementations, during the second phase HCG pixel signal period (2PHS), the multi-pixel (MPX) may generate an electrical signal corresponding to the photocharges generated by the second photoelectric conversion element (PD2), the fourth photoelectric conversion element (PD4), the sixth photoelectric conversion element (PD6), and the eighth photoelectric conversion element (PD8), and may output the electrical signal as the second phase HCG pixel signal. At this time, since the DCG control signal (DCG) is at a logic low level (L), the capacitance of the floating diffusion region (FD) may correspond to a state in which the capacitance is reduced compared to a state in which the DCG control signal (DCG) is at a logic high level (H). For example, during the second phase readout period (2PRO), a preset period from a time point at which the second transfer signal (TG2), the fourth transfer signal (TG4), the sixth transfer signal (TG6), and the eighth transfer signal (TG8) transition from a logic high level (H) to a logic low level (L) to another time point at which the DCG control signal (DCG) transitions from a logic low level (L) to a logic high level (H) may correspond to a second phase HCG pixel signal period (2PHS). For example, the second phase HCG pixel signal period (2PHS) may be a time section in which an electrical signal corresponding to photocharges accumulated in the floating diffusion region (FD) with reduced capacitance is output as a second phase HCG pixel signal. At this time, the photocharges accumulated in the floating diffusion region (FD) may correspond to photocharges which are transferred to the floating diffusion region (FD) during a preset period from a time point at which the second transfer signal (TG2), the fourth transfer signal (TG4), the sixth transfer signal (TG6), and the eighth transfer signal (TG8) transition from a logic low level (L) to a logic high level (H) to another time point at which the second transfer signal (TG2), the fourth transfer signal (TG4), the sixth transfer signal (TG6), and the eighth transfer signal (TG8) transition from a logic high level (H) to a logic low level (L).

In some implementations, during the second phase LCG pixel signal period (2PLS), the multi-pixel (MPX) may generate an electrical signal corresponding to the photocharges generated by the third photoelectric conversion element (PD3), the fifth photoelectric conversion element (PD5), and the seventh photoelectric conversion element (PD7), and may output the electrical signal as the second phase LCG pixel signal. At this time, since the DCG control signal (DCG) is at a logic high level (H), capacitance of the floating diffusion region (FD) may correspond to a state in which the capacitance is increased by the capacitor (C). For example, during the second phase readout period (2PRO), a preset period from a time point at which the DCG control signal (DCG) transitions from a logic low level (L) to a logic high level (H) to another time point at which the reset control signal (RG) transitions from a logic low level (L) to a logic high level (H) may correspond to the second phase LCG pixel signal period (2PLS). For example, the second phase LCG pixel signal period (2PLS) may be a time section in which an electrical signal corresponding to photocharges accumulated in the floating diffusion region (FD) with increased capacitance is output as a second phase LCG pixel signal. At this time, the photocharges accumulated in the floating diffusion region (FD) may correspond to photocharges which are transferred to the floating diffusion region (FD) during a preset period from a time point at which the second transfer signal (TG2), the fourth transfer signal (TG4), the sixth transfer signal (TG6), and the eighth transfer signal (TG8) transition from a logic low level (L) to a logic high level (H) to another time point at which the second transfer signal (TG2), the fourth transfer signal (TG4), the sixth transfer signal (TG6), and the eighth transfer signal (TG8) transition from a logic high level (H) to a logic low level (L).

In some implementations, each of the second phase LCG reset signal and the second phase LCG pixel signal generated during the second phase readout period (2PRO) may be converted into a digital value of the second phase LCG signal (which is a pixel signal corresponding to the second phase readout period 2PRO) through the CDS circuit 130 and the ADC 140. In one example, each of the second phase HCG reset signal and the second phase HCG pixel signal generated during the second phase readout period (2PRO) may be converted into a digital value of the second phase HCG signal (which is a pixel signal corresponding to the second phase readout period 2PRO) through the CDS circuit 130 and the ADC 140.

In some implementations, during the second phase readout period (2PRO), photocharges accumulated in the floating diffusion region (FD) may generate a voltage change in the floating diffusion region (FD), and the voltage change in the floating diffusion region (FD) may be converted into an electrical signal by the source follower transistor (SF). At this time, the degree of voltage change of the floating diffusion region (FD) may be determined by the capacitance of the floating diffusion region (FD). For the same quantity of photocharges, the capacitance of the floating diffusion region (FD) is inversely proportional to the voltage change of the floating diffusion region (FD). That is, when the same quantity of photocharges is transferred from the second photoelectric conversion element (PD2), the fourth photoelectric conversion element (PD4), the sixth photoelectric conversion element (PD6), and the eighth photoelectric conversion element (PD8) to the floating diffusion region (FD), the magnitude of the second phase HCG signal when the DCG control signal is at a logic low level (L) may be greater than the magnitude of the second phase LCG signal when the DCG control signal is at a logic high level (H).

In some implementations, the magnitude of the second phase LCG signal when the DCG control signal is at a logic high level (H) increases with a relatively low slope in response to the increased quantity of photocharges, and the magnitude of the second phase HCG signal when the DCG control signal is at a logic low level (L) increases with a relatively high slope in response to the increased quantity of photocharges. In one example, referring also to FIG. 2, since each of the second phase LCG signal and the magnitude of the second phase HCG signal is converted into image data (IDATA), the response of the second phase LCG signal may follow the response of the low-sensitivity pixel illustrated in FIG. 2, and the response of the second phase HCG signal may follow the response of the high-sensitivity pixel illustrated in FIG. 2. In one example, the image sensing device 100 according to another embodiment of the present disclosure can simultaneously implement the low-sensitivity pixel and the high-sensitivity pixel within only one pixel array 110, and can thus form (or generate) the HDR image using only one image.

Since the pixel array 110 is driven by the row driver 120 on a row basis, a pixel (e.g., a first pixel) including the first photoelectric conversion element (PD1) and a pixel (e.g., one or more second pixels) including the second to eighth photoelectric conversion elements (PD2~PD8) may receive the same reset signal (RG) and the same selection control signal (SEL).

In some implementations, among the pixels included in the multi-pixel (MPX), a pixel (e.g., a first pixel) including the first photoelectric conversion element (PD1) and a pixel (e.g., one or more second pixels) including second to eighth photoelectric conversion elements (PD2~PD8) may distinguish a time point at which photocharges generated in each pixel are transferred to the floating diffusion region (FD). In one example, the multi-pixel (MPX) may receive the first transfer signal (TG1) and the second to eighth transfer signals (TG2~TG8) different from each other.

In some implementations, the HDR controller 300 may control the timing controller 170 through a control signal. At this time, the timing controller 170 may distinguish a time point at which the first transfer signal (TG1) of the logic high level (H) is transferred to the multi-pixel (MPX), a time point at which the third, fifth, and seventh transfer signals (TG3, TG5, TG7) of the logic high level (H) are transferred to the multi-pixel (MPX), and a time point at which the second, fourth, sixth, and eighth transfer signals (TG2, TG4, TG6, TG8) of the logic high level (H) are transferred to the multi-pixel (MPX). In some implementations, the imaging device 10 according to the present disclosure may generate a phase difference image based on the third phase readout period and the fourth phase readout period. For example, the third phase may correspond to a lower phase, and the fourth phase may correspond to an upper phase. In one example, referring also to FIG. 4, the multi-pixel (MPX) may correspond to the first pixel group (PG1), and the third photoelectric conversion element (PD3), the fourth photoelectric conversion element (PD4), the seventh photoelectric conversion element (PD7), and the eighth photoelectric conversion element (PD8) may correspond to high-transmittance pixels (G31, G32) located in an upper region of the fifth microlens (ML5) and high-transmittance pixels (G11, G12) located in an upper region of the first microlens (ML1), respectively. In addition, the second photoelectric conversion element (PD2), the fifth photoelectric conversion element (PD5), and the sixth photoelectric conversion element (PD6) may correspond to high-transmittance pixels (G42) located in a lower region of the fifth microlens (ML5) and high-transmittance pixels (G21, G22) located in a lower region of the first microlens (ML1), respectively.

In some implementations, the operations of the third phase readout period and the fourth phase readout period may be understood in correspondence to the operations of the first phase readout period (1PRO) and the second phase readout period (2PRO) of FIG. 6. For example, the second transfer signal (TG2), the fifth transfer signal (TG5), and the sixth transfer signal (TG6) of the third phase readout period may be understood to perform the same operations as the third transfer signal (TG3), the fifth transfer signal (TG5), and the seventh transfer signal (TG7) of the first phase readout period (1PRO). For example, the third transfer signal (TG3), the fourth transfer signal (TG4), the seventh transfer signal (TG7), and the eighth transfer signal (TG8) of the fourth phase readout period may be understood to perform the same operations as the second transfer signal (TG2), the fourth transfer signal (TG4), the sixth transfer signal (TG6), and the eighth transfer signal (TG8) of the second phase readout period (2PRO), and as such redundant description of the remaining signals (e.g., RG, DG, DCG, TG1, SPG) will herein be omitted for brevity.

In some implementations, the first phase readout period (1PRO) may correspond to a time section for generating a pixel signal for generating a phase-difference image in a first direction. For example, the first direction may correspond to a left direction. In one example, referring also to FIG. 4, the multi-pixel (MPX) may correspond to the first pixel group (PG1), and the third photoelectric conversion element (PD3), the fifth photoelectric conversion element (PD5), and the seventh photoelectric conversion element (PD7) may correspond to a high-transmittance pixel (G31) located in a left region of the fifth microlens (ML5) and high-transmittance pixels (G21, G11) located in a left region of the first microlens (ML1), respectively. In one example, the image signal processor (ISP) 200 may generate a left-right phase difference image based on a left phase difference image and a right phase difference image, and may calculate a phase difference based on a disparity of the left-right phase difference image.

In some implementations, the multi-pixel (MPX) may correspond to a time section for generating a pixel signal used to generate a left-right phase difference image or a top-bottom phase difference image. For example, referring also to FIG. 4, the multi-pixel (MPX) may correspond to the first pixel group (PG1). In one example, the multi-pixel (MPX) may generate a left phase difference image based on pixels (G11, G21, G31, G41) located in the left region, and may generate a right phase difference image based on pixels (G12, G22, G32, G42) located in the right region.

In some implementations, the image signal processor (ISP) 200 may generate a left-right phase difference image based on the left phase difference image and the right phase difference image. Alternatively, the image signal processor (ISP) 200 may generate a top-bottom phase difference image based on an upper phase difference image and a lower phase difference image. In one example, the image signal processor (ISP) 200 may calculate a phase difference based on a disparity of the left-right phase difference image or a disparity of the top-bottom phase difference image. In one example, the image signal processor (ISP) 200 may correct pixel data of the low-transmittance pixel (G41) in response to high-sensitivity pixels (G11, G21, G31, G41).

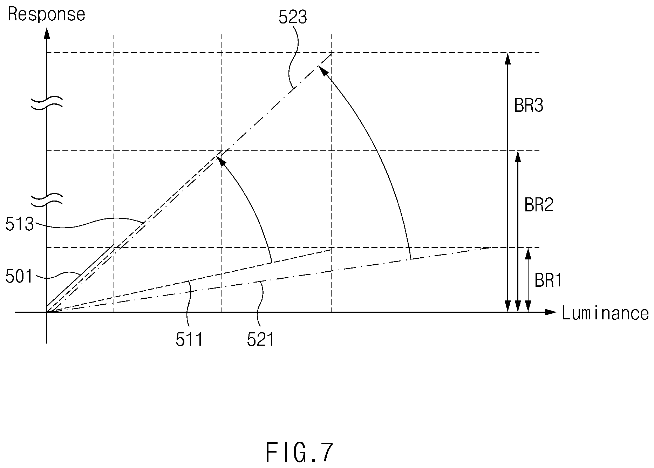

FIG. 7 is a diagram illustrating example operations of the image synthesizer 320 according to an embodiment of the present disclosure.

Referring to FIGS. 1 and 7, the image synthesizer 320 of the image signal processor (ISP) 200 may generate an HDR image by synthesizing at least two or more images with different sensitivities. In one example, the image synthesizer 320 may perform an HDR fusion operation that matches the slope of the output value according to the intensity of incident light of the low-sensitivity pixel with a slope of the output value according to the intensity of incident light of the high-sensitivity pixel. In one example, the output value according to the intensity of incident light of the low-sensitivity pixel and the output value according to the intensity of incident light of the high-sensitivity pixel may have different slopes. For example, referring also to FIG. 2, for the same light intensity, the pixel signal generated by the high-sensitivity pixel may have a high output value, and the pixel signal generated by the low-sensitivity pixel may have a low output value.

In some implementations, in order to generate an HDR image by synthesizing at least two images having different sensitivities, the image synthesizer 320 may match a ratio of the output value according to the intensity of incident light of the low-sensitivity pixel with a ratio of the output value according to the intensity of incident light of the high-sensitivity pixel. This is because the HDR image needs to be synthesized into a single image in which brightness increases consistently as the intensity of light increases.

In some implementations, in a situation in which the DCG capacitor is turned off, when a pixel signal is output based on one photoelectric conversion element that has received the incident light, the output value of the pixel signal according to the intensity of light may represent the same values as those of the first curve 501. At this time, the range of the intensity of light expressed in an image corresponding to the first curve 501 may correspond to a first range (BR1).

In some implementations, in a situation in which the DCG transistor DCX is turned on, when a pixel signal is output based on one photoelectric conversion element that has received the incident light, the output value of the pixel signal according to the intensity of light may represent the same values as those of the second curve 511. In one example, the image synthesizer 320 may adjust the slope of the second curve 511 to convert the output value of the pixel signal according to the intensity of light into the same values as those of the third curve 513. In one example, the range of the intensity of light expressed in the HDR image generated when the image synthesizer 320 synthesizes an image corresponding to the first curve 501 and an image corresponding to the third curve 513 may correspond to a second range (BR2). In one example, the imaging device 10 may obtain an image corresponding to the second curve 511 based on the operation of adjusting the analog gain of the ADC 140.

In some implementations, when the imaging device 10 outputs a pixel signal based on a single low-transmittance photoelectric conversion element (e.g., PD1) that receives low-illuminance incident light, the output value of the pixel signal according to the intensity of light may represent the same values as those of the fourth curve 521. In one example, the image synthesizer 320 may adjust the slope of the fourth curve 521 to convert the output value of the pixel signal according to the intensity of light into the same value as those of the fifth curve 523. At this time, the range of the intensity of light expressed in the HDR image generated by the image synthesizer 320 that synthesizes the image corresponding to the first curve 501, the image corresponding to the third curve 513, and the image corresponding to the fifth curve 523 may correspond to a third range (BR3). In one example, the imaging device 10 may obtain an image corresponding to the third curve 521 based on a first operation of summing photocharges generated by the photoelectric conversion elements (e.g., PD2~PD8) corresponding to a high light transmittance and outputting one pixel signal and/or a second operation of storing overflow charges of the photoelectric conversion element (e.g., PD1) corresponding to a low light transmittance using the capacitor (C).

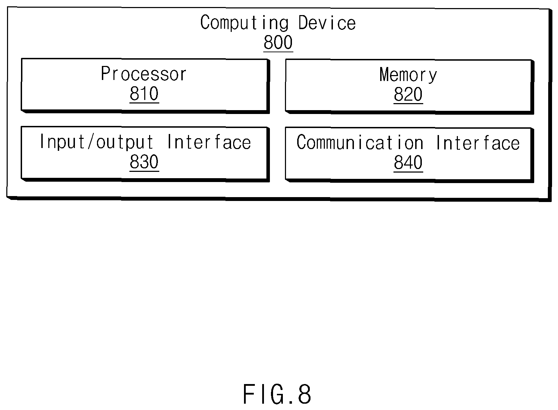

FIG. 8 is a block diagram showing an example of a computing device 800 corresponding to the image signal processor (ISP) 200 of FIG. 1.

Referring to FIG. 8, the computing device 800 may represent an embodiment of a hardware configuration for performing the operation of the image signal processor (ISP) 200 of FIG. 1.

The computing device 800 may be mounted on a chip that is independent from the chip on which the image sensing device is mounted. According to one embodiment, the chip on which the image sensing device is mounted and the chip on which the computing device 800 is mounted may be implemented in one package, for example, a multi-chip package (MCP), but the scope of the present disclosure is not limited thereto.

Additionally, the internal configuration or arrangement of the computing device 800 and the image sensing device may vary depending on the embodiment. For example, at least a portion of the image sensing device may be included in the computing device 800. Alternatively, at least a portion of the computing device 800 may be included in the image sensing device. In this case, at least a portion of the computing device 800 may be mounted together on a chip on which the image sensing device is mounted.

The computing device 800 may include a processor 810, a memory 820, an input and output (input/output) (I/O) interface 830, and a communication interface 840.

The processor 810 may process data and/or instructions required to perform the operations of the components (110, 120) of the image signal processor (ISP) 200 described in FIG. 1. That is, the processor 810 may refer to the image signal processor (ISP) 200, but the scope of the present disclosure is not limited thereto.

The memory 820 may store data and/or instructions required to perform operations of the components 300 of the image signal processor (ISP) 200, and may be accessed by the processor 810. For example, the memory 820 may be volatile memory (e.g., Dynamic Random Access Memory (DRAM), Static Random Access Memory (SRAM), etc.) or nonvolatile memory (e.g., Programmable Read Only Memory (PROM), Erasable PROM (EPROM), etc.), Electrically Erasable PROM (EEPROM), flash memory, etc.).

That is, the computer program for performing the operations of the image signal processor (ISP) 200 disclosed in this document is recorded in the memory 820 and executed and processed by the processor 810, thereby implementing the operations of the image signal processor (ISP) 200.

The input/output (I/O) interface 830 is an interface that connects an external input device (e.g., keyboard, mouse, touch panel, etc.) and/or an external output device (e.g., display) to the processor 810 to allow data to be transmitted and received.

The communication interface 840 is a component that can transmit and receive various data with an external device (e.g., an application processor, external memory, etc.), and may be a device that supports wired or wireless communication.

As is apparent from the above description, the imaging device according to the embodiments of the present disclosure may control overflow charges of a low-transmittance photoelectric conversion element using a single shared capacitor, and may control electrostatic capacitance of a floating diffusion (FD) region of a high-transmittance photoelectric conversion element using the single shared capacitor, so that the imaging device can efficiently generate an HDR image having a maximum dynamic range.

The embodiments of the present disclosure may provide a variety of effects capable of being directly or indirectly recognized through the above-mentioned patent document.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and/or illustrated in this patent document.

## Claims

1. An imaging device comprising:
a split transistor configured to distinguish between a first time during which first pixel data of a first pixel is generated and a second time during which second pixel data of at least one second pixel is generated;
a first photoelectric conversion element connected to a first electrode of the split transistor through a first transfer transistor and included in the first pixel;
a second photoelectric conversion element connected to a second electrode of the split transistor through a second transfer transistor and included in the second pixel;
a floating diffusion region configured to accumulate photocharges generated by the first photoelectric conversion element or the second photoelectric conversion element;
a capacitor configured to adjust capacitance of the floating diffusion region; and
a dual conversion gain (DCG) transistor connected between the capacitor and the floating diffusion region and configured to control the capacitance of the floating diffusion region.

2. The imaging device according to claim 1, wherein:
the first photoelectric conversion element is configured to generate the first pixel data based on the photocharges when the split transistor is turned off; and
the second photoelectric conversion element is configured to generate the second pixel data based on the photocharges when the split transistor is turned on.

3. The imaging device according to claim 1, wherein:
the floating diffusion region is connected to the first electrode; and
the first pixel and the at least one second pixel are configured to share the split transistor, the floating diffusion region, the capacitor, and the DCG transistor.

4. The imaging device according to claim 1, wherein:
the first pixel includes a light blocking structure configured to block at least a portion of incident light,
wherein
the light blocking structure includes a half-shield structure, a neutral-density (ND) filter, or a gray filter.

5. The imaging device according to claim 1, further comprising:
a reset transistor connected to the DCG transistor and configured to reset a voltage level of the floating diffusion region.

6. The imaging device according to claim 1, further comprising:
a drain transistor connected to the second electrode and configured to drain or discharge overflow charges of the second photoelectric conversion element.

7. The imaging device according to claim 6, further comprising:
a signal controller configured to generate a control signal,
wherein
at least one of the split transistor, the DCG transistor, and the drain transistor is configured to be turned on or off based on the control signal.

8. The imaging device according to claim 1, further comprising:
a read controller including a source follower transistor configured to amplify a change in electrical potential of the floating diffusion region, and a selection transistor configured to output, as a pixel signal, an electrical signal received from the source follower transistor.

9. The imaging device according to claim 1, wherein:
the first pixel and the at least one second pixel correspond to color filters of one color, and share a first microlens.

10. The imaging device according to claim 1, further comprising:
a first analog-to-digital converter (ADC) configured to:
compare a first pixel signal generated based on the first pixel with a ramp signal, generate first image data based on a result of the comparison; and
compares a second pixel signal generated based on each of the at least one second pixel with the ramp signal, and generate second image data based on a result of the comparison.

11. The imaging device according to claim 10, further comprising:
a third pixel and at least one fourth pixel; and
a second ADC configured to:
compare a third pixel signal generated based on the third pixel with a ramp signal, and generate third image data based on a result of the comparison; and
compare a pixel signal generated based on the at least one fourth pixel with the ramp signal, and generate fourth image data based on a result of the comparison.

12. The imaging device according to claim 11, further comprising:
an image signal processor configured to generate a phase-difference image using the first image data generated based on the first pixel and the third image data generated based on the third pixel.

13. The imaging device according to claim 10, further comprising:
an image signal processor configured to generate a phase-difference image using the second image data generated based on each of the at least one second pixel.

14. An image sensing method comprising:
generating first pixel data based on first photocharges generated by a first photoelectric conversion element, when a split transistor is turned off and a dual conversion gain (DCG) transistor is turned on, wherein the split transistor is configured to distinguish between photocharges generated by the first photoelectric conversion element and at least one second photoelectric conversion element;
adjusting, to a first capacitance, capacitance of a floating diffusion region configured to accumulate second photocharges generated by the at least one second photoelectric conversion element, when the split transistor is turned on and the DCG transistor is turned on;
generating second pixel data corresponding to a first conversion gain based on the second photocharges;
adjusting the capacitance to a second capacitance when the split transistor is turned on and the DCG transistor is turned off; and
generating third pixel data corresponding to a second conversion gain based on the second photocharges.

15. The image sensing method according to claim 14, further comprising: generating a high dynamic range (HDR) image based on the first to third pixel data.
